# FASCICULE DE BREVET EUROPEEN

(11) **EP 4 218 374 B1**
(45) Date de publication et mention de la délivrance du brevet: **02.07.2025**
(21) Numéro de dépôt: 21783438.1
(22) Date de dépôt: 23.09.2021
(51) Int. Cl.: H05K 7/20

(54) **SYSTÈME ÉLECTRONIQUE DE PUISSANCE**
ELEKTRONISCHES LEISTUNGSSYSTEM
ELECTRONIC POWER SYSTEM

(30) Priorité: 28.09.2020 FR 2009856
(43) Date de publication de la demande: 02.08.2023
(73) Titulaire: Institut Polytechnique de Grenoble, 38000 Grenoble (FR); Université Grenoble Alpes, 38400 Saint-Martin-d'Hères (FR); Centre national de la recherche scientifique, 75016 Paris (FR)
(72) Inventeur: AVENAS, Yvan, 38330 MONTBONNOT SAINT MARTIN (FR); BIKINGA, Wendpanga, 38000 GRENOBLE (FR); MEZRAG, Bachir, 38600 FONTAINE (FR)
(74) Mandataire: Hautier IP
(86) Numéro de dépôt international: PCT/EP2021/076243
(87) Numéro de publication internationale: WO 2022/063921

(56) Documents cités:
- CN-A- 111 541 392
- FR-A1- 3 088 137
- GB-A- 2 565 071
- JP-A- 2014 127 538
- JP-A- 2016 039 206
- JP-A- 2020 145 858
- JP-B2- 6 354 674
- US-A- 5 164 624
- US-A1- 2007 076 355
- US-A1- 2011 242 761
- US-A1- 2012 014 059
- US-A1- 2013 113 090
- US-A1- 2017 317 006
- US-A1- 2019 088 568
- US-A1- 2020 152 547

## Description

### DOMAINE TECHNIQUE

L'invention concerne les systèmes électroniques de puissance. Elle trouve au moins une application particulièrement avantageuse dans le domaine des convertisseurs statiques de puissance.

### ETAT DE LA TECHNIQUE

Un système électronique de puissance tel qu'un convertisseur électronique de puissance comprend généralement des modules de puissance élémentaires connectés entre eux.

Chaque module de puissance élémentaire comprend des composants de puissance, tels que des transistors (par exemple transistors bipolaires à grille isolée IGBT, de l'anglais « Insulated Gate Bipolar Transistor ») et des diodes, assemblés sous forme de puce afin d'assurer une fonction élémentaire, par exemple une fonction d'interrupteur électronique.

La chaleur produite par les composants de puissance des modules de puissance élémentaire doit être dissipée. Le refroidissement de ces modules de puissance élémentaires est une problématique importante pour le bon fonctionnement du système électronique de puissance.

L'encombrement et la masse du système électronique de puissance sont également une problématique importante.

Une solution consiste à intercaler le composant de puissance entre un premier dissipateur thermique conducteur électrique et un deuxième dissipateur thermique conducteur électrique, tel que divulgué par le document brevet FR3088137 A1.

Cette solution permet avantageusement de fonctionnaliser les dissipateurs thermiques du module de puissance. Il est dès lors possible d'assembler plusieurs modules de puissance de façon compacte, sous forme d'un empilement desdits modules de puissance, afin de réaliser des cellules électroniques comprenant au moins deux modules de puissance interconnectés par l'intermédiaire de leurs dissipateurs thermiques.

Le principe d'assemblage des modules entre eux divulgué par le document brevet FR3088137 A1 permet d'envisager différentes typologies de cellules électroniques, comprenant par exemple des modules de puissance en série ou en parallèle.

Le document US5164624 A1 divulgue un autre type d'assemblage modulaire de semiconducteurs de puissance, du type « press-pack », dans lequel les modules sont montés verticalement.

Les connexions externes des cellules électroniques doivent cependant être adaptées à un tel assemblage de modules de puissance élémentaires.

Un objet de la présente invention est de proposer un système électronique de puissance comprenant des modules de puissance en parallèle et des connexions externes optimisées.

Un autre objet de la présente invention est de proposer un système électronique de puissance optimisé, permettant notamment de diminuer la masse et/ou l'encombrement par rapport aux solutions existantes.

Les autres objets, caractéristiques et avantages de la présente invention apparaîtront à l'examen de la description suivante et des dessins d'accompagnement. Il est entendu que d'autres avantages peuvent être incorporés.

### RESUME

L'invention est définie par la revendication indépendante 1. Les modes de réalisation préférés sont définis par les revendications dépendantes.

Un tel système électronique comprenant des modules électroniques (formés chacun par un composant de puissance disposé entre deux dissipateurs thermiques conducteurs électriques) connectés entre eux selon différentes configurations et présentant des connexions externe +DC, -DC et phase, permet avantageusement de réaliser différentes structures du domaine de l'électronique de puissance, telles que des cellules de commutation, des hacheurs, ou des onduleurs, possiblement avec des configurations multiniveaux ou entrelacées.

Un tel système électronique de puissance peut avantageusement être mis en oeuvre pour des applications embarquées nécessitant une faible masse et/ou un faible encombrement, typiquement dans le domaine des transports (aériens ou terrestres).

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 illustre schématiquement une cellule de commutation selon un mode de réalisation de la présente invention.
La figure 2 représente le schéma électrique de la cellule de commutation illustrée à la figure 1.
La figure 3 représente un schéma électrique de quatre cellules de commutation en parallèle, selon un mode de réalisation de la présente invention.
La figure 4 illustre schématiquement un système électronique comprenant un assemblage de quatre cellules de commutation en parallèle, selon un mode de réalisation de la présente invention.
Les figures 5A à 5D illustrent schématiquement différents éléments (boîtier, écrans de compatibilité électromagnétique, cartes de commande etc.) assemblés au système électronique illustré à la figure 4, selon un mode de réalisation de la présente invention.
La figure 6 illustre en coupe le système électronique illustré à la figure 4.
La figure 7 illustre schématiquement un système électronique comprenant un assemblage de quatre cellules de commutation en parallèle, selon un autre mode de réalisation de la présente invention.
La figure 8 illustre schématiquement un système électronique comprenant un assemblage de quatre cellules de commutation en parallèle, selon un autre mode de réalisation de la présente invention.
La figure 9 illustre schématiquement différents éléments (boîtier, écrans de compatibilité électromagnétique, cartes de commande etc.) assemblés au système électronique illustré à la figure 8, selon un mode de réalisation de la présente invention.
La figure 10 illustre schématiquement un système électronique comprenant un assemblage de quatre cellules de commutation en parallèle, selon un autre mode de réalisation de la présente invention.
La figure 11 illustre schématiquement un système électronique comprenant un assemblage de quatre cellules de commutation en parallèle, selon un autre mode de réalisation de la présente invention.
La figure 12 illustre schématiquement différents éléments (boîtier, écrans de compatibilité électromagnétique, cartes de commande etc.) assemblés au système électronique illustré à la figure 11, selon un mode de réalisation de la présente invention.
La figure 13 illustre en coupe le système électronique illustré à la figure 12.
Les figures 14A et 14B illustrent schématiquement un système électronique comprenant un assemblage de quatre cellules de commutation en parallèle, selon un autre mode de réalisation de la présente invention.
La figure 15 illustre schématiquement différents éléments (boîtier, écrans de compatibilité électromagnétique, cartes de commande etc.) assemblés au système électronique illustré aux figures 14A et 14B, selon un mode de réalisation de la présente invention.
La figure 16 illustre en coupe le système électronique illustré à la figure 15.
La figure 17 illustre schématiquement un système électronique comprenant un assemblage de quatre cellules de commutation en parallèle, selon un autre mode de réalisation de la présente invention.
La figure 18 illustre schématiquement un système électronique comprenant un assemblage de quatre cellules de commutation en parallèle, selon un autre mode de réalisation de la présente invention.
La figure 19 illustre schématiquement un système électronique comprenant un assemblage de quatre cellules de commutation en parallèle, selon un autre mode de réalisation de la présente invention.
La figure 20 illustre schématiquement différents éléments (boîtier, écrans de compatibilité électromagnétique, cartes de commande etc.) assemblés au système électronique illustré à la figure 19, selon un mode de réalisation de la présente invention.
La figure 21 illustre schématiquement un système électronique comprenant un assemblage de quatre cellules de commutation en parallèle, selon un autre mode de réalisation de la présente invention.
La figure 22 illustre schématiquement différents éléments (boîtier, écrans de compatibilité électromagnétique, cartes de commande etc.) assemblés au système électronique illustré à la figure 21, selon un mode de réalisation de la présente invention.
La figure 23 illustre schématiquement un système électronique comprenant un assemblage de quatre cellules de commutation en parallèle, selon un autre mode de réalisation de la présente invention.
La figure 24 illustre schématiquement un système électronique comprenant un assemblage de quatre cellules de commutation en parallèle, selon un autre mode de réalisation de la présente invention.
La figure 25 illustre schématiquement différents éléments (boîtier, écrans de compatibilité électromagnétique, cartes de commande etc.) assemblés au système électronique illustré à la figure 24, selon un mode de réalisation de la présente invention.
La figure 26 représente le schéma électrique d'un onduleur monophasé comprenant deux fois deux cellules de commutation en parallèle, selon un mode de réalisation de la présente invention.
La figure 27 illustre schématiquement un onduleur monophasé, selon un mode de réalisation de la présente invention.
La figure 28 illustre schématiquement un onduleur monophasé, selon un autre mode de réalisation de la présente invention.
La figure 29 représente le schéma électrique d'un onduleur triphasé comprenant trois fois huit cellules de commutation en parallèle, selon un mode de réalisation de la présente invention.
Les figures 30A à 30C illustrent schématiquement un onduleur triphasé, selon un mode de réalisation de la présente invention.
La figure 31 illustre en coupe l'onduleur triphasé illustré aux figures 30A à 30C.
La figure 32 représente un schéma électrique d'une cellule de commutation comprenant deux fois quatre composants de puissance en série.
La figure 33 illustre schématiquement une cellule de commutation correspondant au schéma électrique de la figure 32, selon un mode de réalisation de la présente invention.
La figure 34 illustre schématiquement une cellule de commutation correspondant au schéma électrique de la figure 32, selon un autre mode de réalisation de la présente invention.
La figure 35 illustre schématiquement une cellule de commutation correspondant au schéma électrique de la figure 32, selon un autre mode de réalisation de la présente invention.
La figure 36 illustre schématiquement une cellule de commutation correspondant au schéma électrique de la figure 32, selon un autre mode de réalisation de la présente invention.
La figure 37 illustre schématiquement une cellule de commutation correspondant au schéma électrique de la figure 32, selon un autre mode de réalisation de la présente invention.
La figure 38 illustre schématiquement une cellule de commutation correspondant au schéma électrique de la figure 32, selon un autre mode de réalisation de la présente invention.
La figure 39 illustre schématiquement différents éléments (boîtier, écrans de compatibilité électromagnétique, cartes de commande etc.) assemblés à la cellule de commutation illustrée à la figure 37, selon un mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques.

En particulier, les épaisseurs et dimensions des différentes couches et portions des circuits imprimés, des dissipateurs thermiques et des connexions électriques illustrées ne sont pas représentatives de la réalité.

Dans la présente demande de brevet, les notations suivantes sont utilisées :
Pour un module électronique de puissance élémentaire X, on notera :
X0 le circuit imprimé de ce module (comprenant un composant de puissance), X1, X2 les premier et deuxième dissipateurs thermiques de ce module, X00A le composant électronique de puissance de ce module.
Dans la présente demande de brevet, une connexion électrique conductrice entre un dissipateur thermique Xi (i = 1, 2) d'un premier module X et un dissipateur thermique Yj (j = 1, 2) d'un deuxième module Y, est notée : XiYjC
Dans la présente demande de brevet, une connexion électrique capacitive entre un dissipateur thermique Xi (i = 1, 2) d'un premier module X et un dissipateur thermique Yj (j = 1, 2) d'un deuxième module Y, est notée : XiYjCP
Dans la présente demande de brevet, une connexion électrique isolante entre un dissipateur thermique Xi (i = 1, 2) d'un premier module X et un dissipateur thermique Yj (j = 1, 2) d'un deuxième module Y, est notée : XiYjl
Une cellule électronique est notée C0n (n = 1-4).

Toutes les références de chaque module électronique de puissance élémentaire et/ou de chaque cellule électronique ne sont pas nécessairement reportées sur les dessins par souci de clarté.

Les références des éléments non explicitement référencés sur les dessins peuvent être néanmoins déduites facilement à partir des notations explicitées ci-dessus et de la description détaillée qui suit.

### DESCRIPTION DÉTAILLÉE

Selon l'invention, les composants de puissance et les dissipateurs thermiques conducteurs électriques sont assemblés de sorte à former des cellules de commutation élémentaires connectées en parallèle, chaque cellule de commutation élémentaire comprenant :
- Un premier module électronique de puissance élémentaire, dit premier module élémentaire,
- Un deuxième module électronique de puissance élémentaire, dit deuxième module élémentaire,

le premier module élémentaire comprenant :
   - un dissipateur thermique conducteur électrique configuré pour être polarisé selon un potentiel -DC, dit dissipateur anodique, et
   - un dissipateur thermique conducteur électrique configuré pour être polarisé selon un potentiel de phase, dit premier dissipateur de phase,
   - un premier composant de puissance, de préférence intégré sur ou dans un circuit imprimé, disposé entre le dissipateur anodique et le premier dissipateur de phase,
le deuxième module élémentaire comprenant :
   - un dissipateur thermique conducteur électrique configuré pour être polarisé selon un potentiel +DC, dit dissipateur cathodique,
   - un dissipateur thermique conducteur électrique configuré pour être polarisé selon le potentiel de phase, dit deuxième dissipateur de phase,
   - un deuxième composant de puissance, de préférence intégré sur ou dans un circuit imprimé, disposé entre le dissipateur cathodique et le deuxième dissipateur de phase.

Les premier et deuxième modules élémentaires sont adjacents selon une direction de connexion latérale y, et connectés entre eux par une connexion électrique latérale conductrice entre les premier et deuxième dissipateurs de phase, et par une connexion électrique latérale capacitive entre les dissipateurs anodique et cathodique. Ainsi, une cellule de commutation peut être facilement formée en connectant les modules élémentaires entre eux.

Les dissipateurs anodique et cathodique et les dissipateurs de phase des cellules de commutation élémentaires sont configurés pour laisser passer un fluide de refroidissement selon une direction x axiale à la direction de connexion latérale y. Cela permet de refroidir efficacement la cellule de commutation, en minimisant les pertes de charge.

Les cellules de commutation élémentaires sont assemblées les unes derrière les autres selon la direction x axiale, de sorte que les dissipateurs anodiques desdites cellules soient alignés les uns derrière les autres selon la direction x axiale, et que les dissipateurs cathodiques desdites cellules soient alignés les uns derrière les autres selon la direction x axiale, et que les premiers dissipateurs de phase desdites cellules soient alignés les uns derrière les autres selon la direction x axiale, et que les deuxièmes dissipateurs de phase desdites cellules soient alignés les uns derrière les autres selon la direction x axiale. Cela permet de réaliser simplement un système électronique comprenant plusieurs cellules de commutation en parallèle. Cela permet de simplifier le design des connexions externes.

Selon un exemple, la connexion externe de phase se fait sur un premier côté des cellules formé par les premiers et deuxièmes dissipateurs de phase, et les connexions externes +DC et -DC se font sur un deuxième côté des cellules formé par les dissipateurs anodiques et cathodiques, ledit deuxième côté étant opposé au premier côté selon la direction x axiale. Cela permet une meilleure répartition du courant entre les modules élémentaires.

Selon un exemple, le système électronique comprend au moins un premier bloc et un deuxième bloc de cellules de commutation élémentaires assemblées les unes derrière les autres selon la direction x axiale, lesdits au moins premier et deuxième blocs étant adjacents et connectés selon une direction de connexion centrale z de sorte que les premiers et deuxièmes dissipateurs de phase du premier bloc soient connectés aux premiers et deuxièmes dissipateurs de phase du deuxième bloc.

Selon un exemple, les connexions externes +DC et -DC comprennent respectivement des raccords +DC et -DC configurés pour relier respectivement les dissipateurs cathodiques du deuxième bloc avec les dissipateurs cathodiques du premier bloc, et les dissipateurs anodiques du deuxième bloc avec les dissipateurs anodiques du premier bloc.

Selon un exemple, le système électronique comprend au moins un premier bloc et un deuxième bloc de cellules de commutation élémentaires assemblées les unes derrière les autres selon la direction x axiale, lesdits au moins premier et deuxième blocs étant adjacents et séparés selon la direction de connexion latérale y par un espace de séparation. Le fluide de refroidissement s'écoulant selon la direction x traverse ainsi moins de dissipateurs consécutifs. Les pertes de charge sont ainsi réduites.

Selon un exemple, l'espace de séparation comprend au moins une carte de commande configurée pour commander les composants de puissance des cellules de commutation élémentaires de chacun des premier et deuxième blocs, et un calfeutrage configuré pour bloquer un passage du fluide de refroidissement. Le calfeutrage permet d'isoler électriquement les dissipateurs cathodiques du premier bloc des dissipateurs anodiques du deuxième bloc (ou inversement). Le calfeutrage permet en outre de forcer la circulation du fluide de refroidissement dans les dissipateurs. L'efficacité du refroidissement est ainsi améliorée.

Selon un exemple, les dissipateurs cathodiques des premier et deuxième blocs bordent l'espace de séparation. Cela permet de connecter plus facilement l'ensemble des dissipateurs cathodiques d'une part, et l'ensemble des dissipateurs anodiques d'autre part. Cela permet en outre d'ajouter plus facilement un écran de compatibilité électromagnétique en regard des dissipateurs de phase et/ou en regard des dissipateurs cathodiques et/ou en regard des dissipateurs anodiques. Cet écran peut aussi être connecté aux dissipateurs cathodiques ou aux dissipateurs anodiques.

Selon un exemple, les dissipateurs anodiques des premier et deuxième blocs bordent l'espace de séparation. Cela permet de connecter plus facilement l'ensemble des dissipateurs cathodiques d'une part, et l'ensemble des dissipateurs anodiques d'autre part. Cela permet en outre d'ajouter plus facilement un écran de compatibilité électromagnétique en regard des dissipateurs cathodiques et/ou en regard des dissipateurs anodiques.

Selon un exemple, les dissipateurs cathodiques et anodiques des premier et deuxième blocs bordent l'espace de séparation.

Selon un exemple, les premiers et deuxièmes dissipateurs de phase du premier bloc se trouvent sur un côté des cellules du premier bloc opposé à l'espace de séparation.

Selon un exemple, les premiers et deuxièmes dissipateurs de phase du deuxième bloc se trouvent sur un côté des cellules du deuxième bloc opposé à l'espace de séparation.

Selon un exemple, l'espace de séparation comprend les connexions externes +DC et -DC. Cela permet de réduire l'inductance du système.

Selon un exemple, la connexion externe de phase comprend un raccord de phase configuré pour relier les premiers et deuxièmes dissipateurs de phase du deuxième bloc avec les premiers et deuxièmes dissipateurs de phase du premier bloc.

Selon un exemple, les cellules de commutation élémentaires de chacun des premier et deuxième blocs sont assemblées les unes derrière les autres selon la direction x axiale, de sorte que le dissipateur anodique d'une cellule donnée soit aligné avec l'un parmi les premier et deuxième dissipateur de phase d'une cellule immédiatement adjacente selon la direction x axiale, et que le dissipateur cathodique de ladite cellule donnée soit aligné avec l'autre parmi les premier et deuxième dissipateurs de phase de la cellule immédiatement adjacente selon la direction x axiale, lesdits dissipateurs anodiques et cathodiques étant isolés électriquement vis-à-vis desdits premier et deuxième dissipateurs de phase. Un tel assemblage permet de réduire le champ magnétique engendré par les cellules lors des commutations. L'inductance parasite au sein du système électronique est ainsi réduite.

Selon un exemple, les connexions externes +DC et -DC sont reliées à un jeu de barres ou busbar. Un busbar peut se présenter sous forme d'un PCB ou sous forme de plusieurs couches conductrices/isolantes assemblées les unes sur les autres (busbar laminé).

Selon un exemple, le busbar est disposé transversalement à la direction x axiale, le busbar étant configuré pour laisser passer le fluide de refroidissement. Le busbar peut notamment comprendre des passages pour l'écoulement du fluide de refroidissement. Dans ce cas, il peut jouer le rôle d'écran de compatibilité électromagnétique (CEM). Il n'est donc pas nécessaire d'ajouter un tel écran CEM supplémentaire.

Selon un exemple, le busbar se présente sous forme d'une grille perforée.

Selon un exemple, le système électronique comprend en outre au moins une carte de commande entourant les cellules de commutation élémentaires, de sorte à ce que ladite au moins une carte de commande forme un boîtier configuré pour canaliser le fluide de refroidissement selon la direction x axiale. Le fait de canaliser le fluide de refroidissement directement par les cartes de commande (PCB) permet de réduire la masse totale du système. Un boitier de canalisation distinct n'est plus nécessaire. Les PCB sont fonctionnalisés pour canaliser le fluide de refroidissement, en plus de la commande des composants de puissance.

Selon un exemple, une première partie des cellules de commutation élémentaires présente des premiers et deuxièmes dissipateurs de phase configurés pour être polarisés selon un premier potentiel de phase et une deuxième partie des cellules de commutation élémentaires présente des premiers et deuxièmes dissipateurs de phase isolés électriquement vis-à-vis des premiers et deuxièmes dissipateurs de phase de la première partie des cellules, et configurés pour être polarisés selon un deuxième potentiel de phase différent du premier potentiel de phase.

Selon un exemple, au moins une connexion externe de phase comprend une première connexion externe de phase connectée aux dissipateurs polarisés selon le premier potentiel de phase, et une deuxième connexion externe de phase connectée aux dissipateurs polarisés selon le deuxième potentiel de phase.

Selon un exemple, les cellules de commutation élémentaires de la première partie sont connectées via leurs premiers et deuxièmes dissipateurs de phase selon une direction de connexion centrale z, et les cellules de commutation élémentaires de la deuxième partie sont connectées via leurs premiers et deuxièmes dissipateurs de phase selon la direction de connexion centrale z, de sorte que les dissipateurs de phase des cellules de la première partie soient alignés avec les dissipateurs de phase des cellules de la deuxième partie selon la direction x axiale.

Selon un exemple, les cellules de commutation élémentaires de la première partie sont connectées via leurs premiers et deuxièmes dissipateurs de phase selon la direction x axiale, et les cellules de commutation élémentaires de la deuxième partie sont connectées via leurs premiers et deuxièmes dissipateurs de phase selon la direction x axiale, de sorte que les dissipateurs de phase des cellules de la première partie soient alignés avec les dissipateurs de phase des cellules de la deuxième partie selon une direction de connexion centrale z. Une telle configuration d'assemblage permet d'ajouter facilement d'autres cellules de commutation élémentaires à chacune des parties (ou bras de l'onduleur), en les alignant les unes derrières les autres selon la direction x.

Selon un exemple, une troisième partie des cellules de commutation élémentaires présente des premiers et deuxièmes dissipateurs de phase configurés pour être polarisés selon un troisième potentiel de phase, et dans lequel l'au moins une connexion externe de phase comprend une troisième connexion externe de phase connectée aux dissipateurs polarisés selon le troisième potentiel de phase.

Selon un exemple, le système comprend en outre un boîtier configuré pour entourer la pluralité de dissipateurs thermiques conducteurs électriques de façon à canaliser un passage d'un fluide de refroidissement dans lesdits dissipateurs thermiques conducteurs électriques.

Selon un exemple, le système comprend en outre au moins un écran de comptabilité électromagnétique configuré pour être polarisé selon le potentiel +DC ou - DC, entourant au moins partiellement l'au moins un dissipateur de phase. Cela permet de limiter le rayonnement électromagnétique ainsi que les effets négatifs des courants de mode commun lors des commutations des composants.

Selon un exemple, le système comprend en outre au moins une carte de commande configurée pour commander la pluralité de composants de puissance et entourant au moins partiellement la pluralité de dissipateurs thermiques conducteurs électriques. Cela permet de fonctionnaliser la carte de commande, par exemple pour assurer une fonction de canalisation du fluide de refroidissement, ou pour assurer une fonction d'écran de comptabilité électromagnétique (CEM). La carte de commande peut en outre commander les composants de puissance des modules élémentaires. Une carte de commande sous forme de PCB est relativement légère. Cela permet de diminuer le poids total du système.

Dans la présente invention, les premier et deuxième dissipateurs thermiques sont dits anodique ou cathodique par souci de clarté. Cette dénomination n'est pas limitative de l'invention. Les dissipateurs anodique et cathodique forment des électrodes. Ces électrodes peuvent être une anode, une cathode, un émetteur, un collecteur, une source, un drain, etc. Ces électrodes peuvent être interverties selon le sens passant du composant électronique par exemple.

Dans la présente invention, on utilise de préférence des transistors MOSFETs qui incluent une diode dans leur structure. Il est possible d'utiliser des transistors de type « IGBT », c'est-à-dire des transistors bipolaire à grille isolée (IGBT, de l'anglais « Insulated Gate Bipolar Transistor »). Dans ce cas, le transistor IGBT est de préférence associé à une diode en antiparallèle, par exemple située dans le PCB.

D'autres architectures de transistors peuvent être utilisées, par exemple mais de façon non limitative :
- un transistor de type HEMT (acronyme de « High Electron Mobility Transistor »), qui est un transistor à effet de champ à haute mobilité d'électrons, parfois également désigné par le terme de transistor à effet de champ à hétérostructure,
- un transistor à effet de champ à grille isolée plus couramment nommé MOSFET (acronyme anglais de « Metal Oxide Semiconductor Field Effect Transistor »).

D'autres composants, tels que des thyristors, des thyristors à extinction par gâchette (thyristor GTO ou plus simplement GTO, de l'anglais « Gate Turn-Off » Thyristor), peuvent également être utilisés.

Ces transistors et composants sont bien connus et couramment utilisés dans le domaine de l'électronique de puissance, en particulier pour des convertisseurs statiques de puissance. Dans la suite, les termes « transistor » ou « composant » ou « composant de puissance » peuvent donc s'entendre, de façon non limitative, de l'ensemble des architectures de transistors et de composants mentionnés ci-dessus.

On entend par système électronique dans le domaine de l'électronique de puissance des systèmes fonctionnant de préférence avec des courants électriques présentant des intensités comprises entre 10 A et 1000 A, et/ou des tensions électriques comprises entre 10 V et 10000 V, de préférence entre 10 V et 5000 V, et de préférence entre 10 V et 1000 V.

Selon l'invention, le système électronique est constitué de plusieurs modules élémentaires comprenant chacun des composants de puissance assurant en particulier une ou des fonctions d'interrupteur électronique.

Le système est donc avantageusement modulaire et permet de réaliser de nombreuses structures de convertisseurs statiques, tels qu'une cellule de commutation, un convertisseur multiniveaux, un hacheur entrelacé.

Ces modules peuvent être connectés selon les trois directions de l'espace x, y et z. Une connexion latérale se fait selon la direction y. Une connexion centrale se fait selon z. Une connexion axiale se fait selon x. Un repère xyz, de préférence orthonormé, est joint aux dessins d'accompagnement. Il permet notamment de faciliter la compréhension des différentes connexions des modules entre eux. La direction x définit notamment un sens d'écoulement d'un fluide de refroidissement au travers du système électronique. Dans les exemples présentés, le refroidissement se fait typiquement par air en convection forcée. Alternativement, le refroidissement peut se faire par refroidissement liquide avec ou sans changement de phase, à condition que le liquide soit isolant électrique. Le refroidissement peut alternativement se faire en convection naturelle.

Le principe de modularité du système électronique selon l'invention est illustré au travers des exemples suivants.

Le lecteur se référera utilement au contenu des documents FR3088137 A1 et WO2020094663 A1 pour la réalisation des modules de puissance élémentaires et pour la connexion de ces modules entre eux de façon à former un système électronique de puissance. Les caractéristiques des dissipateurs et des connexions conductrices, capacitives ou isolantes décrites dans ces documents sont notamment incorporées dans la présente demande. D'autres modes de réalisation sont présentés dans ce qui suit. Une partie de la description s'attache aux connexions « externes » des modules élémentaires, par opposition aux connexions « internes » décrites précédemment dans les documents FR3088137 A1 et WO2020094663 A1.

De façon générale et sauf mention explicite du contraire, les différents dissipateurs X2, Y2, U2, V2, A2, B2, I2, J2 sont des dissipateurs de phase polarisés à un potentiel de phase, les dissipateurs X1, U1, A1, I1, sont des dissipateurs anodiques polarisés à un potentiel -DC, les dissipateurs Y1, V1, B1, J1 sont des dissipateurs cathodiques polarisés à un potentiel +DC.

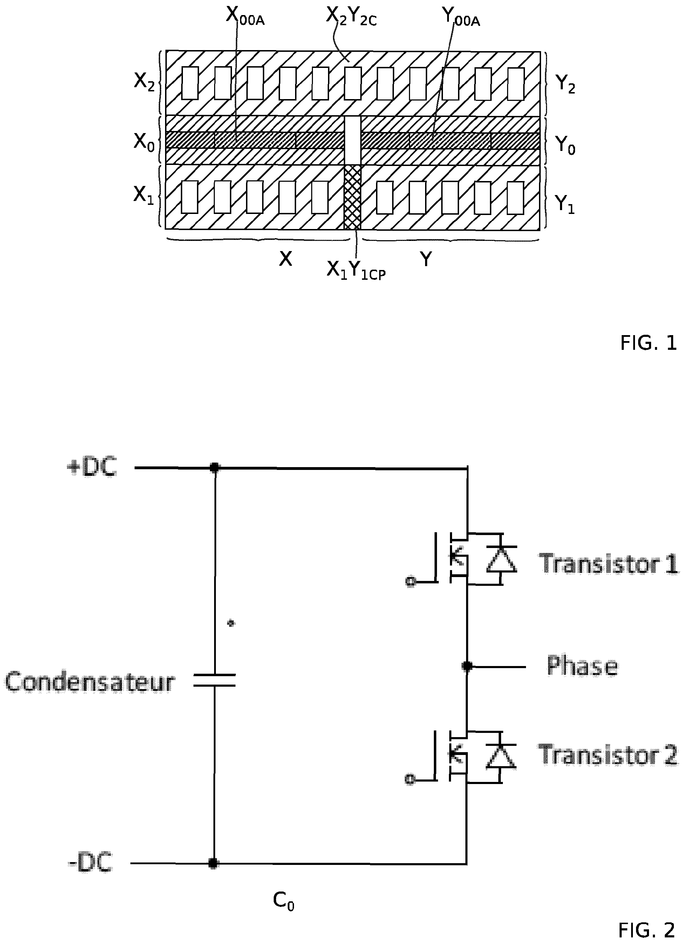

La figure 1 présente une cellule de commutation élémentaire formée par deux modules de puissance élémentaires X, Y connectés latéralement entre eux. **En** particulier, le premier module de puissance X comprend un circuit imprimé ou PCB X0 intercalé entre un premier dissipateur X1 et un deuxième dissipateur X2. Le deuxième module de puissance Y comprend un circuit imprimé ou PCB Y0 intercalé entre un premier dissipateur Y1 et un deuxième dissipateur Y2. Les premier et deuxième circuits imprimés X0, Y0 comprennent respectivement au moins un premier et un deuxième composants de puissance X00A, Y00A, de préférence un premier et un deuxième transistors. Le choix de composants de puissance intégrés dans un PCB permet de simplifier les connexions électriques externes avec une carte de commande. D'autres solutions alternatives au PCB, permettant notamment d'intercaler un composant de puissance entre les dissipateurs, sont également envisageables.

Pour chacun des modules élémentaires, il n'y a pas d'élément isolant électrique entre le PCB X0, respectivement Y0, et les dissipateurs X1, X2, respectivement Y1, Y2. Afin de limiter les interfaces thermiques, les transistors X00A, Y00A sont de préférence des puces nues. Alternativement, les transistors X00A, Y00A peuvent être assemblés préalablement dans des boîtiers individuels.

De façon générale, les dissipateurs sont configurés pour laisser passer un fluide de refroidissement au moins selon la direction x.

Le premier dissipateur X1 peut être configuré pour être polarisé à un potentiel -DC. Il est dénommé dissipateur anodique dans la suite.

Le premier dissipateur Y1 peut être configuré pour être polarisé à un potentiel +DC. Il est dénommé dissipateur cathodique dans la suite.

Les deuxièmes dissipateurs X2, Y2 peuvent être configurés pour être polarisés à un potentiel de phase. Ils sont dénommés dissipateurs de phase dans la suite.

Dans cet exemple, pour former une cellule de commutation élémentaire C0 telle qu'illustrée par le schéma électrique de la figure 2, les dissipateurs anodiques et cathodiques X1, Y1 sont connectés latéralement entre eux par une connexion latérale capacitive X1Y1CP. Les dissipateurs de phase X2, Y2 sont connectés latéralement entre eux par une connexion latérale conductrice X2Y2C.

La connexion latérale conductrice X2Y2C illustrée à la figure 1 est réalisée par le biais d'un seul et unique dissipateur de phase XY comprenant les dissipateurs X2, Y2. Selon une autre possibilité, les dissipateurs X2, Y2 sont distincts et connectés entre eux par brasure, par frittage, ou par collage avec une colle conductrice.

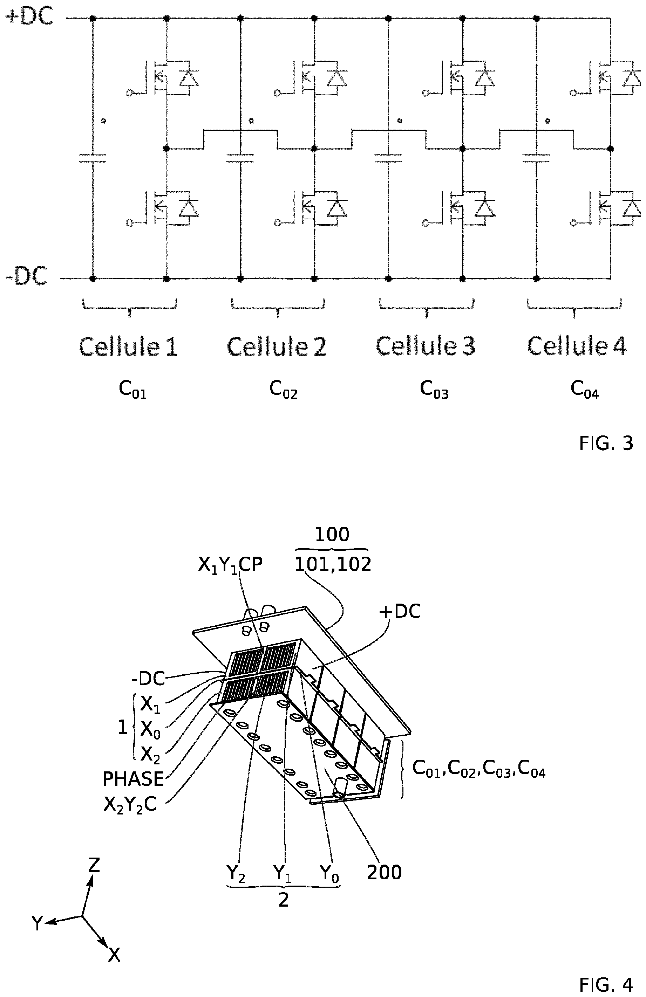

La figure 3 illustre un schéma électrique d'un système électronique dans lequel quatre cellules de commutation élémentaires C01, C02, C03, C04 sont connectées en parallèle. En pratique, dans la suite, la cellule C01 comprend les dissipateurs anodiques et cathodiques X1, Y1 et les dissipateurs de phase X2, Y2. La cellule C02 comprend les dissipateurs anodiques et cathodiques U1, V1 et les dissipateurs de phase U2, V2. La cellule C03 comprend les dissipateurs anodiques et cathodiques A1, B1 et les dissipateurs de phase A2, B2. La cellule C04 comprend les dissipateurs anodiques et cathodiques I1, J1 et les dissipateurs de phase I2, J2. Par souci de clarté, les références ne sont pas nécessairement reportées sur chacune des figures d'accompagnement. L'homme du métier saura néanmoins reproduire sans difficulté les différentes configurations de système électronique sur la base de la description et des illustrations.

Les figures 4 à 25 illustrent différents modes de réalisation pratiques du système électronique défini à la figure 3.

Selon un premier mode de réalisation illustré à la figure 4, les quatre cellules élémentaires C01, C02, C03, C04 sont alignées les unes derrière les autres selon la direction x.

La connexion électrique entre les différentes cellules élémentaires C01, C02, C03, C04 est assurée par une connexion externe de phase 200 entre les différents dissipateurs de phase X2, Y2, U2, V2, A2, B2, I2, J2, et par une connexion externe -DC 101 entre les différents dissipateurs anodiques X1, U1, A1, I1, et par une connexion externe +DC 102 entre les différents dissipateurs cathodiques Y1, V1, B1, J1. La connexion externe de phase 200 se présente typiquement sous forme d'une plaque métallique 200.

Les connexions externes -DC et +DC 101, 102 se présentent typiquement sous forme d'un busbar 100. Le busbar 100 peut être de plusieurs types, par exemple et de façon connue : des plaques, un busbar laminé ou un PCB.

La plaque métallique 200 et le busbar 100 permettent également d'assurer le maintien mécanique des cellules élémentaires C01, C02, C03, C04. La connexion électrique entre la plaque métallique 200 et les cellules élémentaires d'une part, et entre le busbar 100 et les cellules élémentaires d'autre part, peut être faite de différentes manières. Par exemple et de façon connue, cette connexion peut se faire par des vis, ou par soudure, ou par brasure, ou par une colle conductrice électrique et thermique, ou par frittage, ou par frittage en phase liquide transitoire (TLPS). Une connexion par vis permet un montage et un démontage facilité des cellules. Des cellules défectueuses peuvent ainsi être facilement et avantageusement remplacées. Une brasure ou une soudure permettent d'améliorer le contact électrique.

Dans cet exemple, les cellules élémentaires C01, C02, C03, C04 peuvent être en contact les unes avec les autres ou espacées entre elles.

De façon préférée, la plaque métallique 200 et le busbar 100 se situent de part et d'autres du bloc de cellules élémentaires C01, C02, C03, C04, sur deux côtés opposés. Cela permet une meilleure répartition du courant électrique entre les cellules élémentaires.

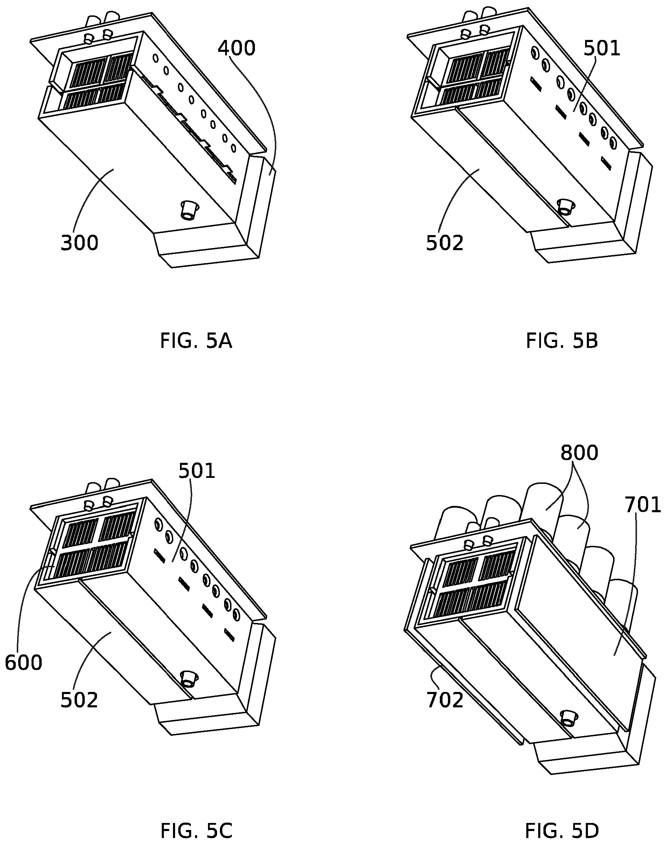

Les figures 5A à 5D présentent des éléments qui peuvent être ajoutés autour du bloc de cellules de commutation élémentaires illustré à la figure 4. Comme illustré à la figure 5A, un boîtier 300 peut être avantageusement disposé autour du bloc de cellules élémentaires. Ce boitier 300 permet typiquement de canaliser selon x le fluide de refroidissement dans les dissipateurs des cellules élémentaires. Cela permet de gagner en performance de refroidissement.

Ce boitier 300 est de préférence isolant électrique. Il peut être réalisé de différentes façons, par exemple par impression 3D, par usinage, ou par injection de plastique ou de résine. Pour parfaire l'étanchéité du boitier 300 ou pour combler des espaces permettant à l'air de passer entre les dissipateurs, une mousse isolante ou toute autre matière pouvant assurer l'étanchéité peut être utilisée. Ce boitier 300 peut comprendre des fixations 400 pour un ou des ventilateurs.

Comme illustré à la figure 5B, des écrans 501, 502 de compatibilité électromagnétique (CEM) peuvent être avantageusement disposés autour du bloc de cellules élémentaires. Ces écrans 501, 502 CEM sont typiquement configurés pour limiter le rayonnement électromagnétique ainsi que les courants de mode commun lors des commutations des composants de puissance des cellules de commutation. Ces écrans 501, 502 se présentent typiquement sous forme de plaques conductrices polarisées à des potentiels fixes. Ces écrans 501, 502 CEM sont de préférence au moins disposés en regard des dissipateurs de phase, et de préférence en regard des dissipateurs anodiques et cathodiques. L'écran 501 est de préférence situé sur un côté des dissipateurs cathodiques et polarisé selon le potentiel +DC. L'écran 502 est de préférence situé sur un côté des dissipateurs anodiques et polarisé selon le potentiel -DC. Les écrans 501, 502 CEM peuvent se présenter sous forme de plaques, de films, de toiles métalliques. Il est également possible d'utiliser des PCB comprenant une ou plusieurs pistes conductrices, par exemple sous forme de grille, polarisées selon un ou plusieurs potentiels. La masse d'un tel écran 501, 502 basé sur un PCB est avantageusement diminuée par rapport à la masse d'une plaque métallique. On peut également envisager de réaliser les circuits de commande des transistors directement sur ces écrans 501, 502 de type « PCB ».

Pour limiter encore les problèmes de compatibilité électromagnétique, il est possible d'ajouter un écran 600 en face de la sortie et/ou de l'entrée d'air, comme illustré à la figure 5C. Cet écran 600 peut être perforé ou texturé afin de laisser passer le fluide de refroidissement. Il est typiquement polarisé selon un potentiel fixe +DC ou -DC. Il peut alternativement être relié à la terre. Les écrans CEM 501, 502, 600 peuvent avantageusement recouvrir au maximum les dissipateurs de phase raccordés au potentiel de phase. Le potentiel de phase est en effet celui qui varie le plus au cours du temps. Les écrans CEM sont donc plus efficaces en regard des dissipateurs de phase. Selon une possibilité, les dissipateurs anodiques et cathodiques ne sont pas recouverts par les écrans CEM. Cela permet de limiter la masse ou l'encombrement du système.

Comme illustré à la figure 5D, des cartes de commandes 701, 702 peuvent être reliées aux cellules de commutation, par exemple pour commander les composants de puissance de ces cellules. Des condensateurs 800 de découplage peuvent également être ajoutés au niveau du busbar 100. Un filtre à air (non illustré) peut également être ajouté pour limiter l'encrassement sur les dissipateurs. Cela permet de réduire les risques de claquage diélectrique. Ce filtre est de préférence choisi de sorte à imposer le moins de pertes de charge possible. Cela permet de garder une bonne efficacité pour le refroidissement du système électronique.

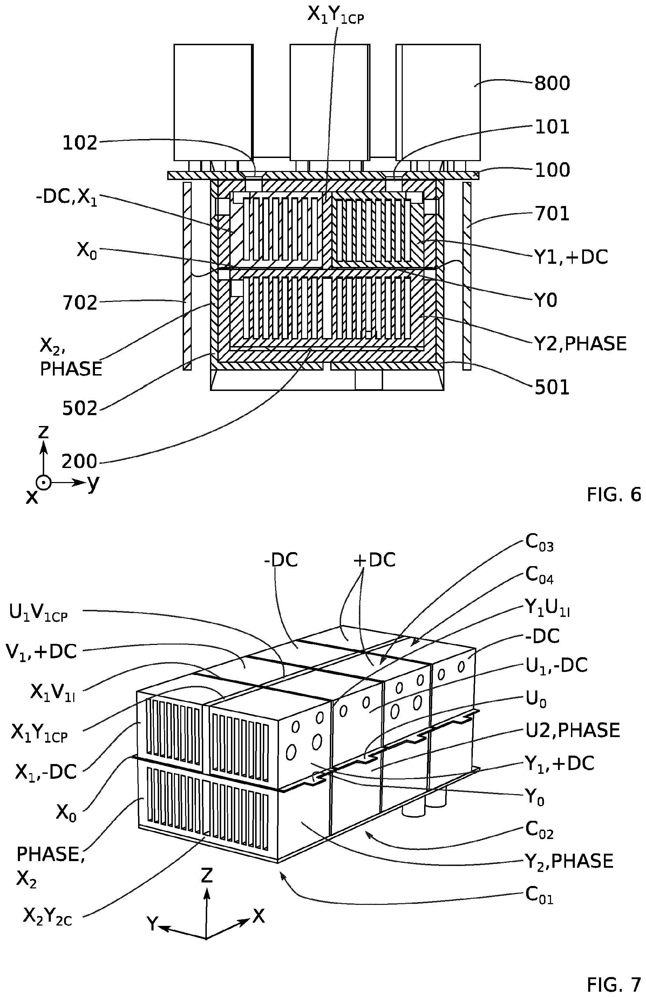

La figure 6 présente une vue en coupe du système électronique présenté à la figure 5D. Cette vue permet de voir plus précisément certaines connexions électriques, telles que la connexion latérale capacitive X1Y1CP entre les dissipateurs anodique X1 et cathodique Y1, la connexion latérale conductrice X2Y2C entre les dissipateurs de phase X2, Y2, et les connexions d'écrans CEM entre les écrans 501, 502 et les dissipateurs anodique et cathodique X1, Y1.

La vue en coupe de la figure 6 montre également la connexion entre les cartes de commande 701, 702 et les PCB X0, Y0 des modules élémentaires.

D'autres arrangements de cellules élémentaires sont envisageables pour former le système électronique illustré à la figure 3.

Différents principes d'arrangement de ces cellules élémentaires sont ainsi présentés dans la suite. Les éléments additionnels du système, tels que les plaques 200, busbar 100, boitier 300, 400, écrans 501, 502, 600, cartes 701, 702, ne sont pas systématiquement repris dans les dessins d'accompagnement. Cela n'exclut pas la possibilité d'ajouter ces éléments tel que décrit ci-dessus.

La figure 7 illustre une possibilité d'arrangement dans laquelle la disposition des dissipateurs anodiques et cathodiques est modifiée par rapport à l'exemple précédent. Dans cet exemple, les dissipateurs anodiques et cathodiques sont alternés selon x. Cela permet d'alterner les potentiels +DC et -DC. Des champs magnétiques inverses sont ainsi créés. Cela diminue l'inductance parasite au sein des cellules de commutation.

Il est ici nécessaire d'isoler électriquement entre eux les dissipateurs qui ne sont pas au même potentiel. Cela peut être fait en les espaçant et/ou en mettant un matériau isolant entre eux. Par exemple, le dissipateur cathodique Y1 est connecté au dissipateur anodique U1 par une connexion axiale isolante Y1AU1I. Le dissipateur anodique X1 est connecté au dissipateur cathodique V1 par une connexion axiale isolante X1V1I.

D'autres possibilités non illustrées d'arrangement des cellules élémentaires alignées selon x sont également envisageables. L'homme du métier saura facilement choisir quel arrangement de cellules convient le mieux en fonction de ses besoins, grâce à la modularité du système électronique présenté ici.

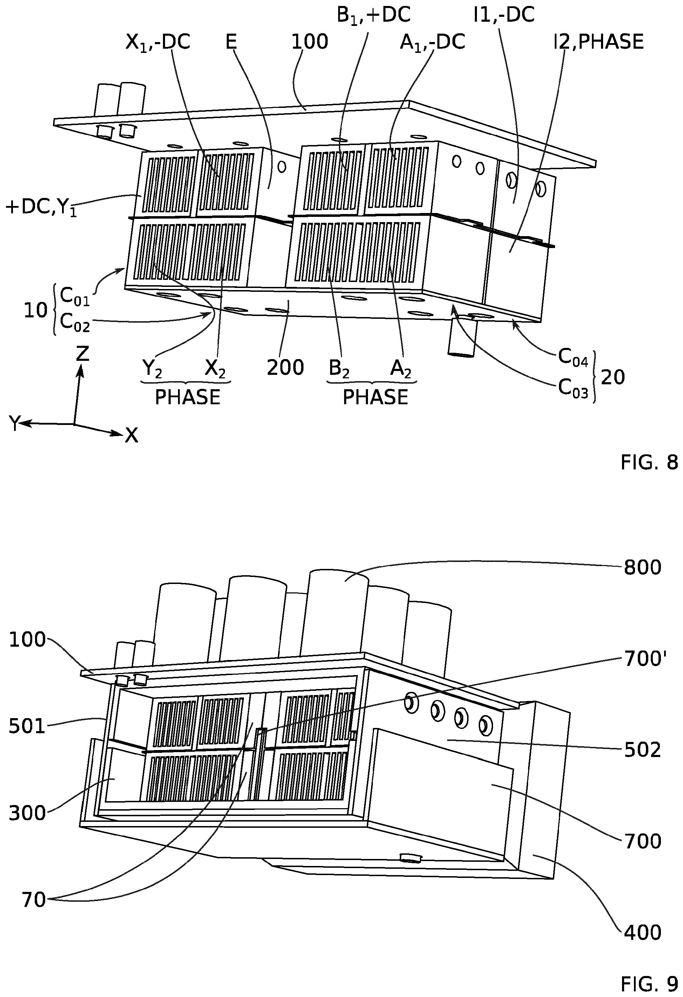

Les figures 8 à 20 présentent différents modes de réalisation de ce même système électronique (quatre cellules de commutation en parallèle) basés sur une juxtaposition transverse, selon une direction axiale à x, de deux blocs de cellules élémentaires10, 20.

Ainsi, comme illustré à la figure 8, un premier bloc 10 de deux cellules C01, C02 est disposé à côté d'un deuxième bloc 20 de deux cellules C03, C04.

Le premier bloc 10 comprend deux cellules élémentaires C01, C02 alignées les unes derrière les autres selon la direction x, comme précédemment. Le deuxième bloc 20 comprend deux cellules élémentaires C03, C04 alignées les unes derrière les autres selon la direction x, comme précédemment. Cette disposition permet de réduire l'épaisseur de dissipateurs à traverser selon x pour le fluide de refroidissement. Cela permet de réduire les pertes de charge de l'écoulement du fluide dans le système.

Les premier et deuxième blocs 10, 20 peuvent être séparés par un espace E de séparation. Cela permet d'isoler électriquement les dissipateurs anodiques X1, V1 du premier bloc 10 vis-à-vis des dissipateurs cathodiques B1, J1 du deuxième bloc 20. Cela permet également de réserver un accès pour la connectique des blocs 10, 20.

Comme précédemment, le busbar 100 relie électriquement les dissipateurs anodiques entre eux, et les dissipateurs cathodiques entre eux. La connexion des dissipateurs de phase est effectuée par une plaque métallique 200.

Comme illustré à la figure 9, un boitier 300, 400, des écrans CEM 501, 502, 600 (l'écran CEM 600 en face des blocs de cellules n'est pas représenté sur la figure 9 afin de laisser visible l'intérieur du système) et des cartes de commande 700, 700' peuvent être ajoutés autour des blocs de cellules élémentaires.

Dans cet exemple, une carte de commande 700' est disposée dans l'espace E de séparation entre les premier et deuxième blocs, afin de commander les transistors se trouvant au centre du système. Cette carte de commande 700' peut également être une simple connectique reliée à la carte de commande 700 externe. Selon une possibilité préférée, l'espace E de séparation est calfeutré par un matériau isolant ou autre dispositif permettant de bloquer au moins partiellement l'écoulement d'air. Cela permet de forcer l'écoulement du fluide de refroidissement dans les dissipateurs. L'efficacité du refroidissement est améliorée. Le matériau isolant peut être massif. Alternativement et de façon avantageuse, ce matériau peut se présenter sous forme d'une mousse déformable. Cela permet de limiter la masse du système. Cela permet également d'obstruer facilement certaines zones, par exemple autour de la carte de commande 700'. Selon une autre possibilité, l'espace de séparation est calfeutré par injection de résine, notamment autour de la carte de commande 700'.

Comme précédemment, d'autres possibilités d'arrangement des cellules élémentaires sont envisageables.

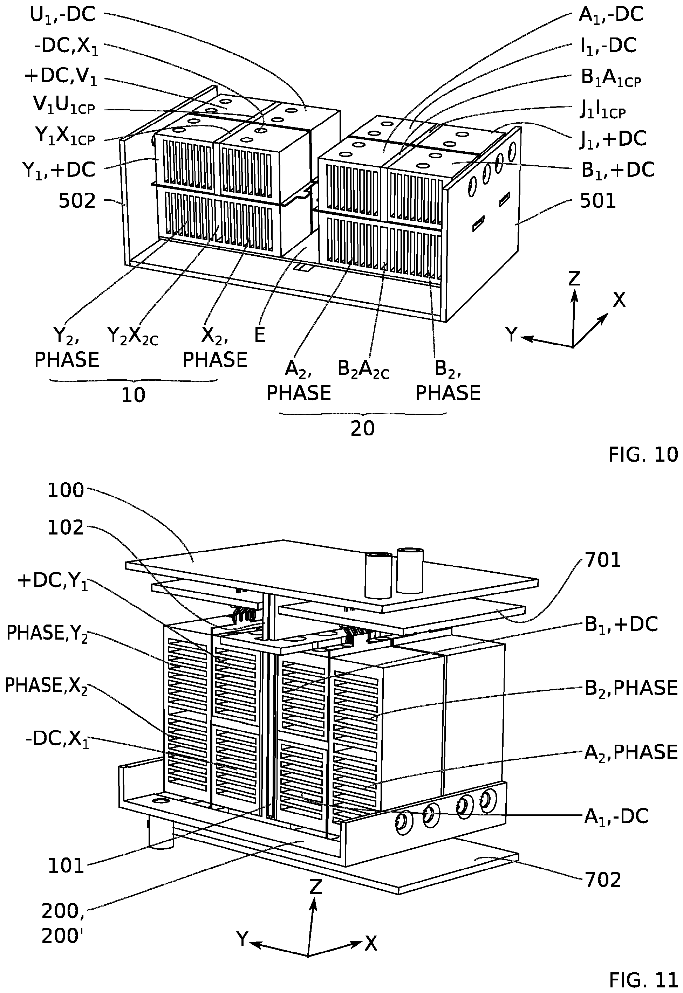

La figure 10 présente un exemple d'arrangement où tous les dissipateurs cathodiques sont situés sur les côtés des blocs 10, 20, opposés à l'espace de séparation E. Cela permet de former un écran CEM 501 continu autour des dissipateurs de phase et des dissipateurs cathodiques B1, J1, Y1, V1. L'écran CEM 501 est ainsi formé par une seule plaque métallique.

Comme précédemment, d'autres possibilités d'arrangement non représentées sont également possibles. Les dissipateurs cathodiques et anodiques peuvent être inversés. Les dissipateurs cathodiques et anodiques peuvent être alternés en quinconce.

La figure 11 présente un autre mode de réalisation où l'ensemble des dissipateurs anodiques et cathodiques des deux blocs 10, 20 borde l'espace de séparation E. Dans cet exemple, l'espace de séparation E comprend les connexions externes 101, 102 +DC et -DC. Ces connexions externes 101, 102 +DC et -DC se présentent typiquement sous forme de plaques reliées au busbar 100. De telles plaques 101, 102 parallèles entre elles sur toute leur longueur et polarisées selon +DC et -DC permettent de réduire l'inductance parasite.

Les cartes de commande 701, 702 sont simplement disposées de part et d'autre des blocs. La connexion externe de phase 200 comprend un raccord de phase 200' configuré pour relier les dissipateurs de phase situés sur les côtés opposés des blocs de cellules.

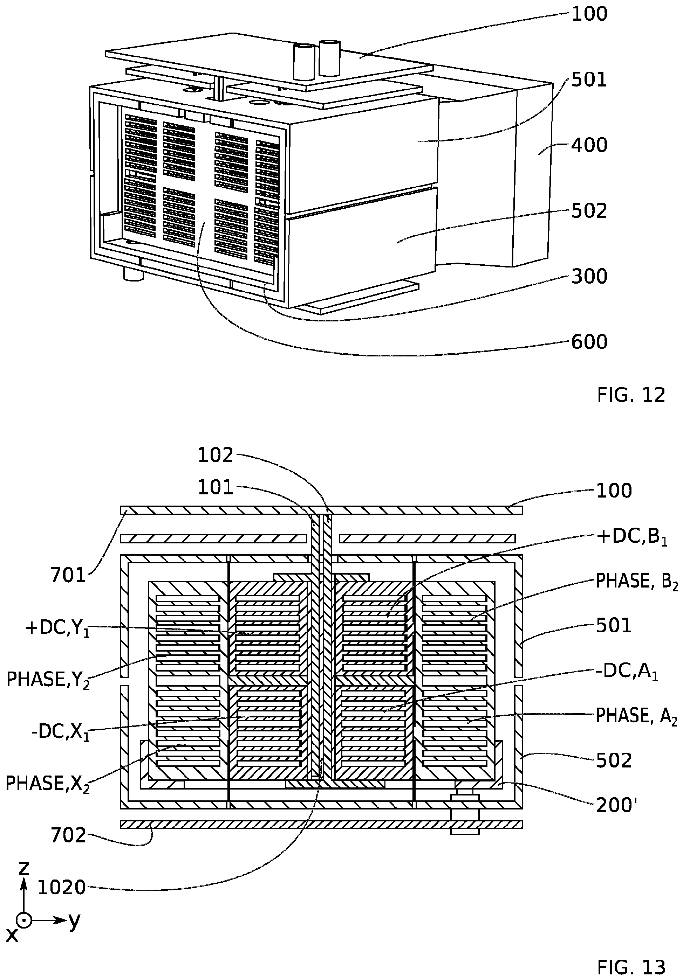

La figure 12 illustre les éléments additionnels (boitier 300, 400, écrans CEM 501, 502, 600) ajoutés au système électronique illustré à la figure 11.

La figure 13 est une vue en coupe du système, montrant notamment les connexions électriques entre la plaque 101 et les dissipateurs cathodiques Y1, B1 d'une part, et entre la plaque 102 et les dissipateurs anodiques X1, A1 d'autre part. Ces connexions sont ici représentées par des vis mais elles pourraient être faites alternativement par brasure, par collage, ou par frittage par exemple.

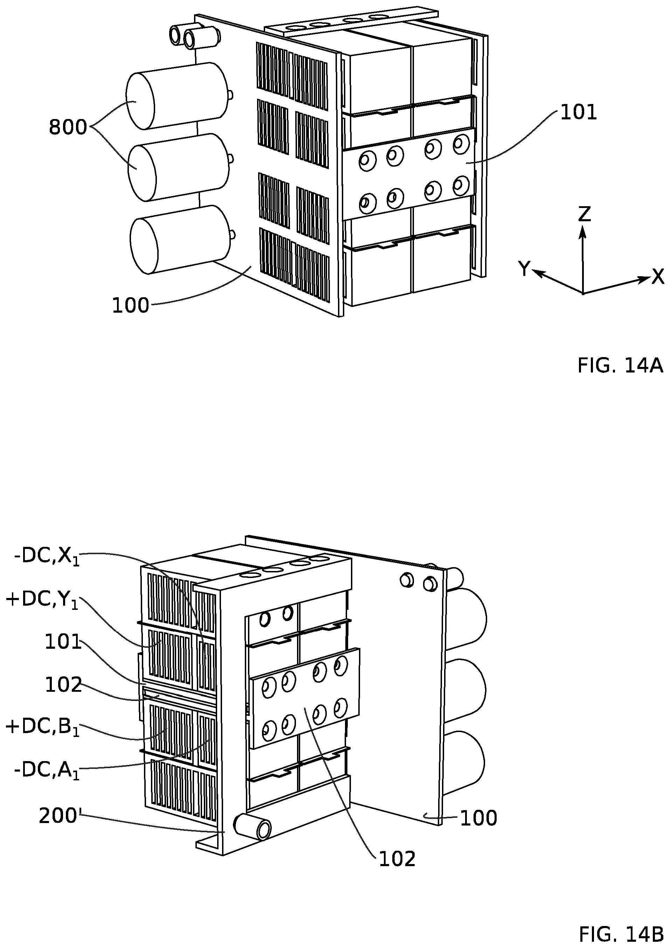

Selon un autre mode de réalisation, le busbar 100 peut être placé perpendiculairement à l'écoulement d'air. Le busbar 100 peut alors être massif s'il est suffisamment éloigné des cellules de façon à laisser au moins un passage pour la circulation d'air. Selon une possibilité illustrée à la figure 14A, le busbar 100 comprend des perforations pour le passage de l'air. Dans ce cas, il peut avantageusement jouer le rôle d'écran CEM. Cela limite le nombre d'écrans CEM à ajouter au système. La masse totale du système est diminuée. Une plaque 101 peut relier les dissipateurs cathodiques au busbar 100. Une plaque 102 peut relier les dissipateurs anodiques au busbar 100, comme illustré à la figure 14B. Comme précédemment, un raccord de phase 200' peut permettre de relier entre eux les dissipateurs de phase.

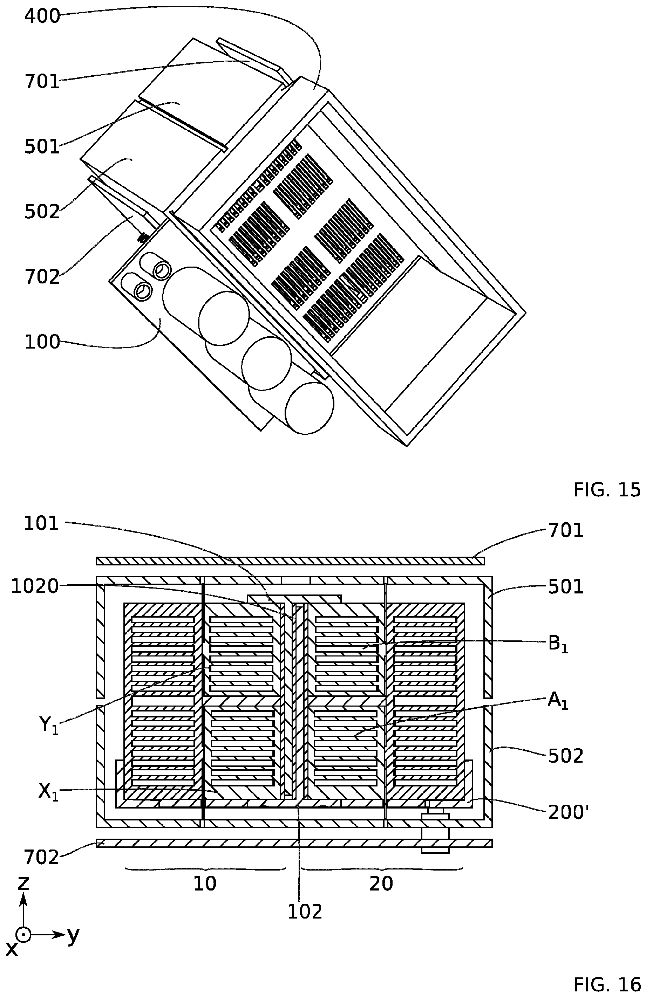

La figure 15 illustre les éléments additionnels (boitier 300, 400, écrans CEM 501, 502, cartes de commande 701, 702) ajoutés au système électronique illustré aux figures 14A et 14B.

Sur la figure 15, le busbar perforé 100 est situé côté ventilateur. Il peut alternativement être placé du côté opposé au ventilateur.

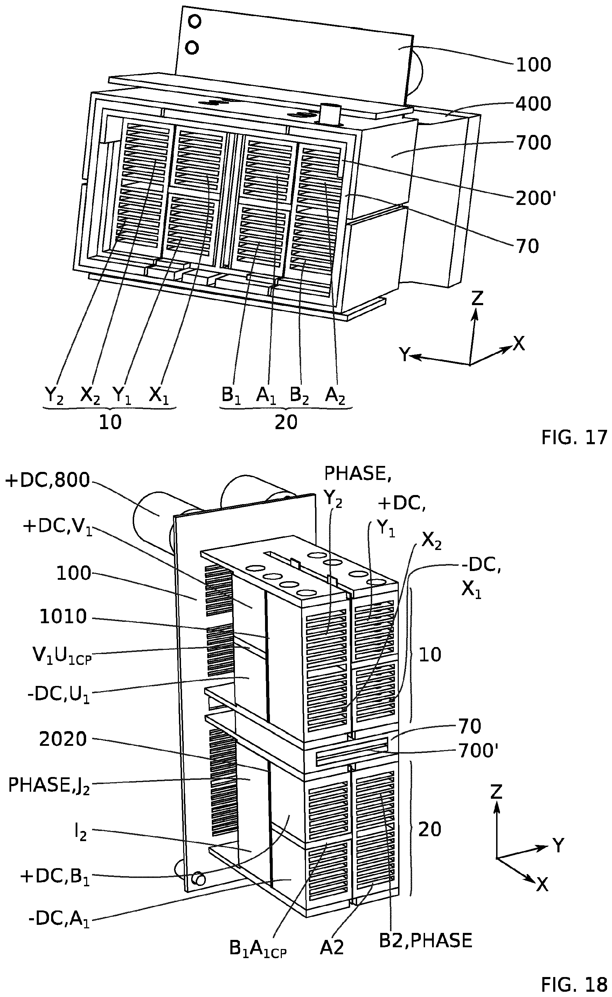

La figure 16 est une vue en coupe du système, montrant notamment les connexions électriques entre la plaque 101 et les dissipateurs cathodiques Y1, B1 d'une part, et entre la plaque 102 et les dissipateurs anodiques X1, A1 d'autre part. Ces connexions sont ici représentées par des vis mais elles pourraient être faites alternativement par brasure, par collage, ou par frittage par exemple. Les plaques 101, 102 sont parallèles entre elles sur toute leur longueur afin de réduire au maximum l'inductance vis-à-vis des condensateurs externes 800. Le design des plaques 101, 102 peut être adapté en fonction des besoins. Par exemple, si le besoin consiste à diminuer la masse du système, des plaques plus courtes peuvent convenir (comme illustré à la figure 17). Si le besoin consiste à limiter au maximum l'inductance parasite, des plaques parallèles entre elles sur toute leur longueur sont préférables, comme illustré à la figure 16.

Selon une possibilité illustrée à la figure 17, des PCB 700 peuvent être disposés autour des cellules pour canaliser l'air dans le système. Les PCB 700 remplacent dès lors le boitier 300. Cela permet de réduire la masse totale du système. Les PCB 700 peuvent également assurer la fonction d'écran CEM. Ils peuvent en outre assurer la fonction de commande des transistors des cellules de commutation. Le boitier basé sur les PCB est ainsi avantageusement fonctionnalisé. Un matériau isolant 70, tel qu'une mousse, peut être utilisé pour calfeutrer les espaces entre le boitier et les blocs de cellules élémentaires.

La figure 18 illustre une autre possibilité d'arrangement des cellules de commutation en parallèle. La disposition relative des dissipateurs anodiques et cathodiques au sein de chaque bloc 10, 20 permet ici de réduire le champ magnétique engendré par les cellules lors des commutations. L'inductance parasite est ainsi diminuée. La connexion entre les différents dissipateurs et le busbar 100 peut être réalisée par des plaques conductrices multicouches 101, 102, 200. Ces plaques conductrices multicouches peuvent se présenter sous forme de PCB ou de busbar laminés. Alternativement, les connexions peuvent être réalisées par de simples plaques séparées par des isolants électriques.

Des isolants électriques 1010, 2020 peuvent être prévus entre les dissipateurs de phase d'une cellule donnée et les dissipateurs anodique et cathodique d'une cellule adjacente.

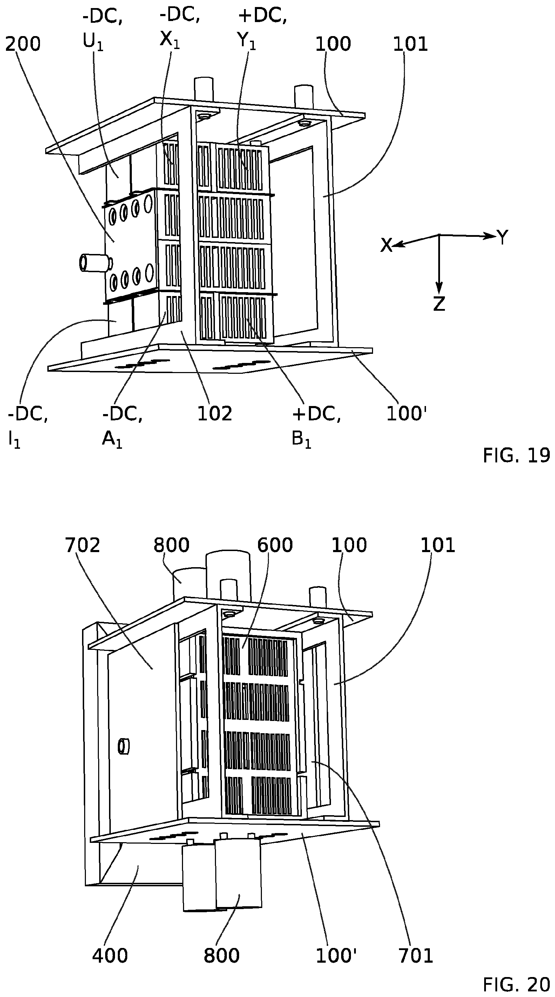

La figure 19 présente un mode de réalisation où les deux blocs de cellules sont adjacents par leurs dissipateurs de phase. Une plaque de phase 200 relie les dissipateurs de phase entre eux. Dans ce cas, le busbar peut être scindé en plusieurs parties 100, 100'. Des raccords 101, 102 peuvent alors permettre de relier ces deux parties 100, 100' aux dissipateurs cathodiques et anodiques.

La figure 20 illustre les éléments additionnels (boitier 400, écran CEM 600, cartes de commande fonctionnalisées 701, 702, condensateurs de découplage 800) ajoutés au système électronique illustré à la figure 19.

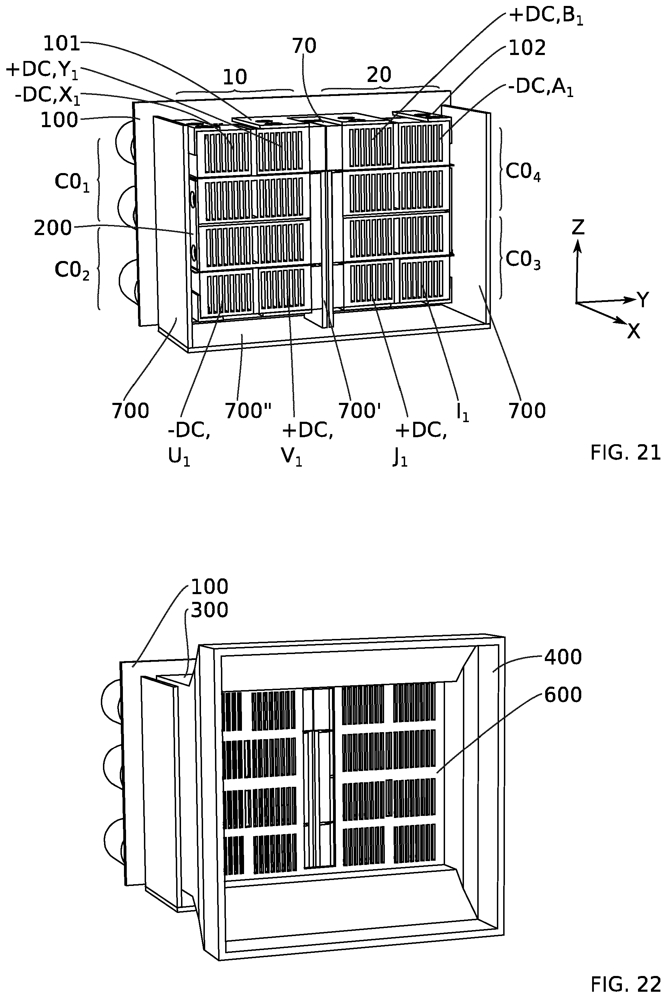

Les figures 21 à 25 présentent différents modes de réalisation de ce même système électronique (quatre cellules de commutation en parallèle) basés sur une juxtaposition transverse, selon une direction axiale à x, de toutes les cellules élémentaires.

Comme illustré à la figure 21, les quatre cellules de commutation peuvent être juxtaposées selon y et/ou z. Les dissipateurs sont disposés selon un seul rang, parallèlement au plan yz. Cela permet de diminuer encore les pertes de charge dans les dissipateurs lors du refroidissement.

Comme précédemment, un premier bloc 10 de deux cellules C01, C02 est disposé à côté d'un deuxième bloc 20 de deux cellules C03, C04.

Le premier bloc 10 comprend deux cellules élémentaires C01, C02 connectées par une connexion centrale entre les dissipateurs de phase X2, Y2, U2, V2. Le deuxième bloc 20 comprend deux cellules élémentaires C03, C04 connectées par une connexion centrale entre les dissipateurs de phase A2, B2, I2, J2. Cette disposition permet de réduire l'épaisseur de dissipateurs à traverser selon x pour le fluide de refroidissement. Cela permet de réduire les pertes de charge de l'écoulement du fluide dans le système.

Les premier et deuxième blocs 10, 20 peuvent être séparés par un espace E de séparation, comme précédemment. Cet espace peut typiquement comprendre une ou des cartes de commande 700'. Une mousse isolante 70 peut calfeutrer l'espace restant entre les cartes 700' et les blocs de cellules 10, 20.

Dans le mode de réalisation illustré à la figure 21, le busbar 100 est placé perpendiculairement à l'écoulement d'air. Il est configuré pour délivrer les potentiels +DC, -DC et phase. Il est relié aux dissipateurs par des plaques métalliques 101, 102, 200. La commande des composants de puissance peut s'effectuer à partir d'une carte mère 700" reliée aux cartes de commande 700, 700' qui amènent les signaux de commande jusqu'aux transistors des cellules de commutation élémentaires.

La figure 22 illustre les éléments additionnels (boitier 300, 400, écran CEM 600, condensateurs de découplage 800) ajoutés au système électronique illustré à la figure 21.

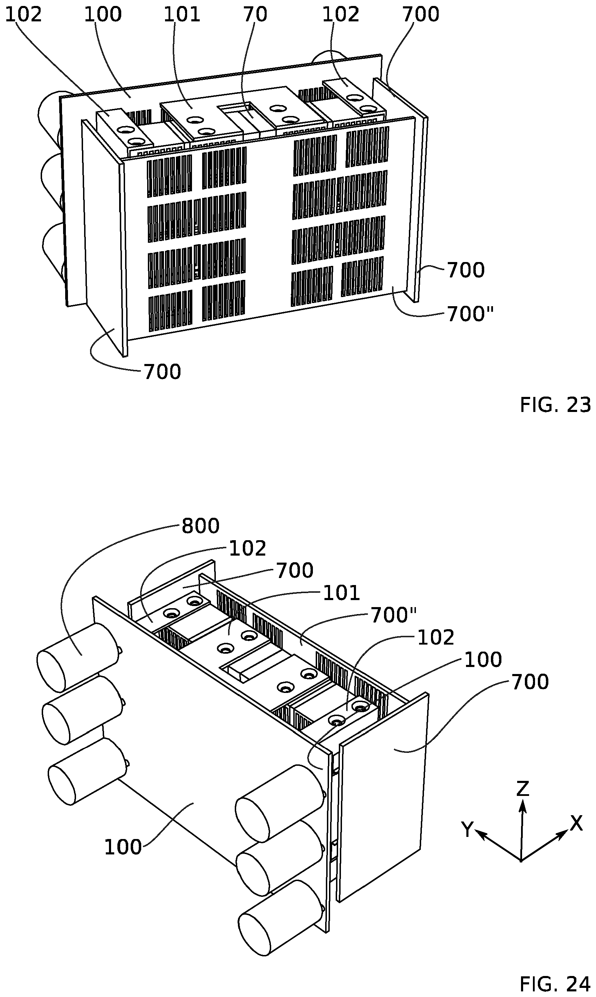

Dans le mode de réalisation illustré à la figure 23, la carte mère 700" est perforée et placée perpendiculairement à l'écoulement d'air, comme le busbar 100. Elle peut alors jouer le rôle d'écran CEM. Cette carte est de préférence reliée à toutes les autres cartes de commande 700, 700' (sur le côté et entre les dissipateurs).

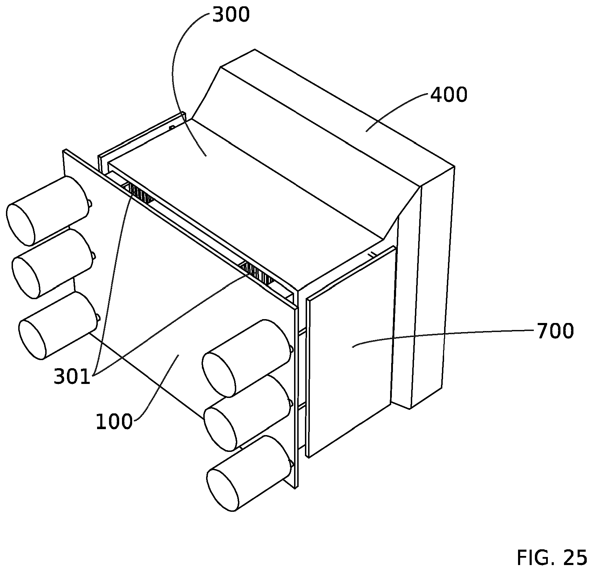

Dans le mode de réalisation illustré aux figures 24 et 25, la carte mère 700" est perforée et placée perpendiculairement à l'écoulement d'air. Le busbar 100 est massif et placé perpendiculairement à l'écoulement d'air. Dans ce cas, le busbar 100 est suffisamment éloigné des cellules de façon à laisser au moins un passage 301 pour la circulation d'air, par exemple entre le boitier 300 et le busbar 100.

Les agencements de cellules décrits précédemment illustrent la modularité du système électronique. D'autres systèmes électroniques, typiquement des systèmes multiphasés avec potentiellement de nombreux composants en parallèle, peuvent être facilement dérivés des agencements décrits plus haut. Dans la suite, des modes de réalisation d'onduleurs monophasé et triphasé sont présentés.

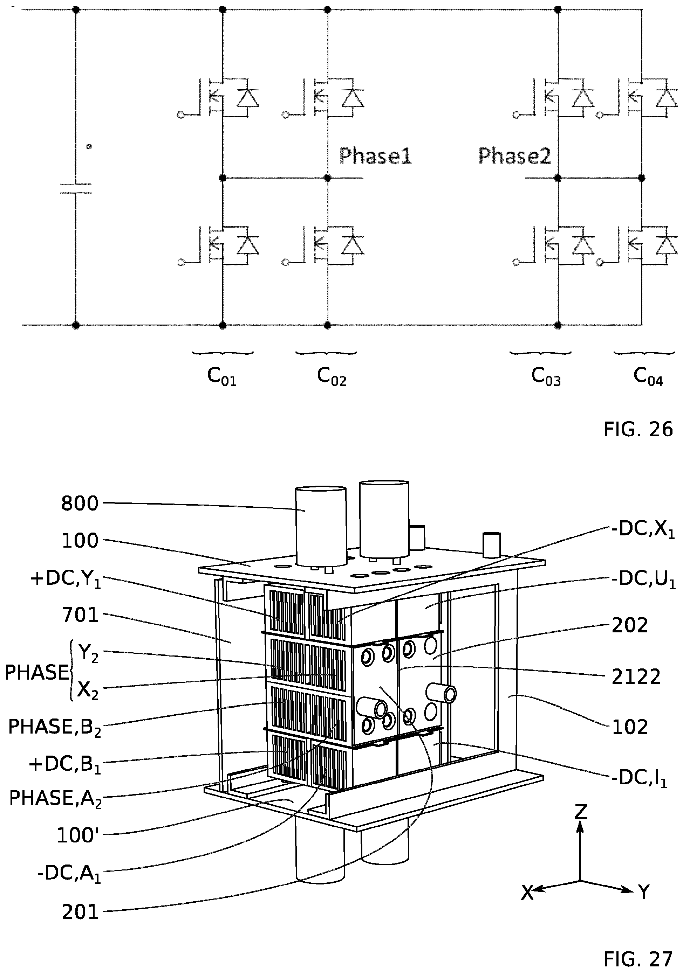

La figure 26 illustre un schéma électrique d'un système électronique d'onduleur de tension monophasé deux niveaux, dans lequel chaque bras d'onduleur comprend deux cellules de commutation en parallèle.

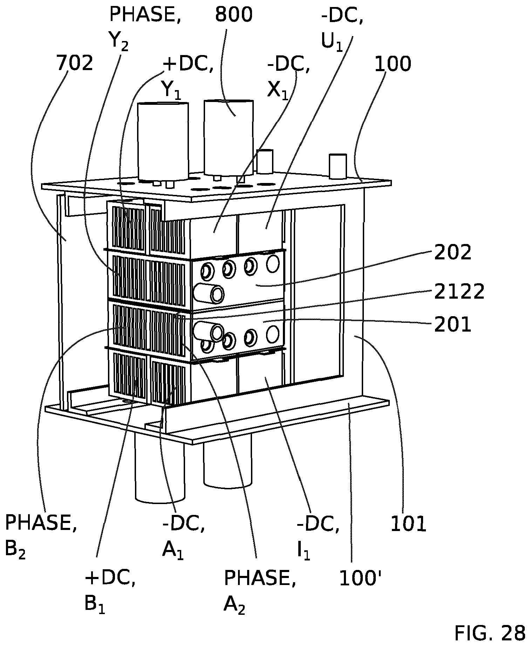

Les figures 27 et 28 illustrent deux exemples de réalisation d'un tel onduleur monophasé.

Dans le mode de réalisation illustré à la figure 27, les deux bras d'onduleur sont formés par deux blocs de cellules alignés selon x. Le premier bloc comprend les deux cellules connectées centralement par leurs dissipateurs de phase A2, B2, X2, Y2. Une plaque de phase 201, configurée pour être polarisée selon un premier potentiel de phase, relie les dissipateurs A2, B2, X2, Y2 entre eux. Le deuxième bloc comprend les deux cellules connectées centralement par leurs dissipateurs de phase V2, U2, I2, J2. Une plaque de phase 202, configurée pour être polarisée selon un deuxième potentiel de phase, relie les dissipateurs V2, U2, I2, J2 entre eux. Un isolant 2122 permet d'isoler les dissipateurs de phase qui ne sont pas au même potentiel. Cet isolant s'étend ici selon un plan yz.

Dans le mode de réalisation illustré à la figure 28, les deux bras d'onduleur sont formés par deux blocs de cellules superposés selon z. Le premier bloc comprend les deux cellules connectées axialement par leurs dissipateurs de phase A2, B2, I2, J2. Une plaque de phase 201, configurée pour être polarisée selon un premier potentiel de phase, relie les dissipateurs A2, B2, I2, J2 entre eux. Le deuxième bloc comprend les deux cellules connectées axialement par leurs dissipateurs de phase V2, U2, X2, Y2. Une plaque de phase 202, configurée pour être polarisée selon un deuxième potentiel de phase, relie les dissipateurs V2, U2, X2, Y2 entre eux. Comme précédemment, un isolant 2122 permet d'isoler les dissipateurs de phase qui ne sont pas au même potentiel. Cet isolant s'étend ici selon un plan xy. Il est possible d'ajouter facilement d'autres cellules élémentaires sur chaque bras d'onduleur en les alignant selon x et en les connectant axialement avec les cellules déjà connectées, et en allongeant selon x les plaques de phase 201, 202.

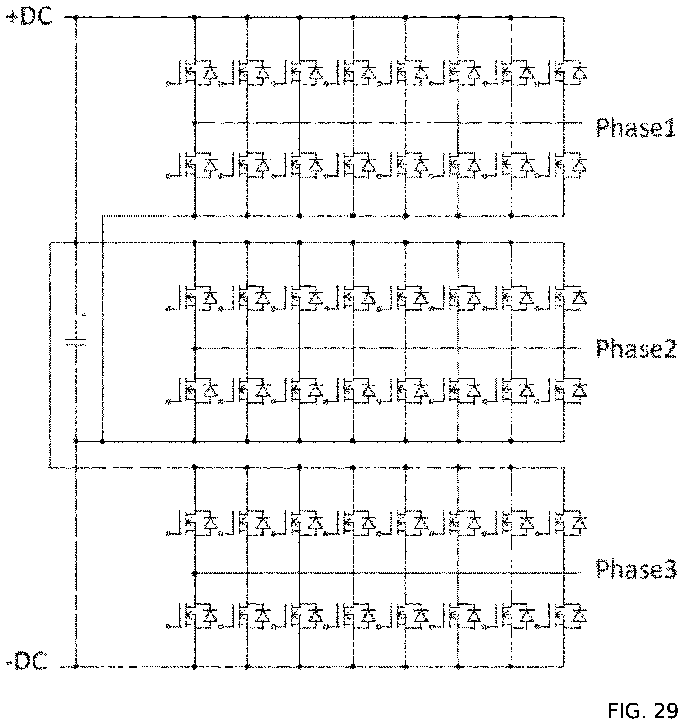

La figure 29 illustre un schéma électrique d'un système électronique d'onduleur de tension triphasé deux niveaux, dans lequel chaque bras d'onduleur comprend huit cellules de commutation en parallèle.

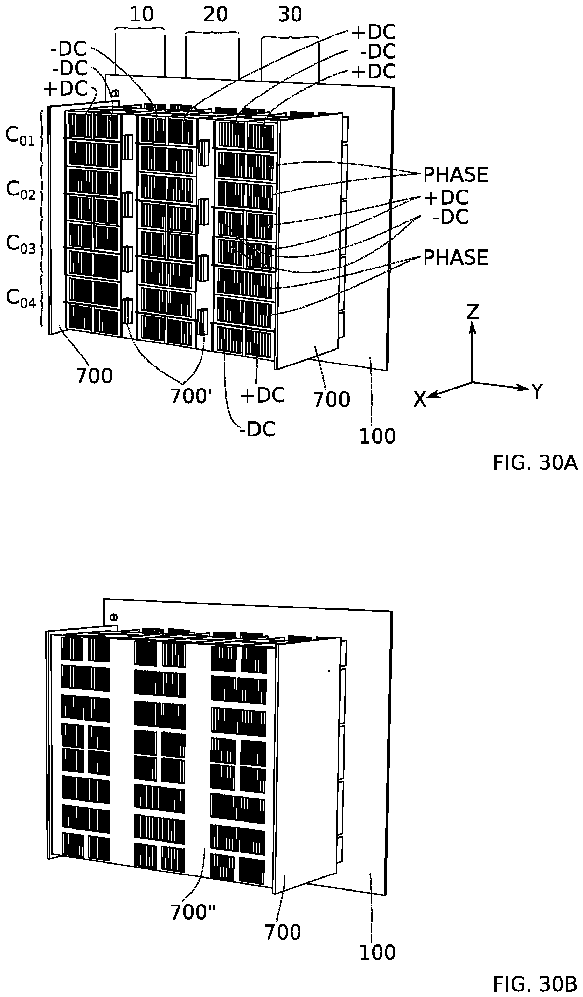

La figure 30A illustre un exemple de réalisation d'un onduleur triphasé dérivé du schéma électrique de la figure 29, dans lequel chaque bras d'onduleur comprend huit cellules de commutation en parallèle.

Dans ce mode de réalisation, les trois bras d'onduleur sont formés par trois blocs 10, 20, 30 de cellules, lesdits blocs étant adjacents selon y. Chaque bloc comprend deux sous-blocs de cellules, lesdits sous-blocs étant alignés et connectés axialement entre eux. Chaque sous-bloc comprend quatre cellules connectées centralement. Par exemple, le premier sous-bloc du bloc 10 comprend les cellules C01, C02, C03, C04. Les cellules C01, C02 sont connectées centralement par leurs dissipateurs de phase. Les cellules C02, C03 sont connectées centralement par leurs dissipateurs anodiques et cathodiques. Les cellules C03, C04 sont connectées centralement par leurs dissipateurs de phase. Le même type de connexion peut être réalisé pour les cellules des autres sous-blocs des blocs 10, 20, 30.

Les dissipateurs de phase du premier bloc sont configurés pour être polarisés selon un premier potentiel de phase. Les dissipateurs de phase du deuxième bloc sont configurés pour être polarisés selon un deuxième potentiel de phase. Les dissipateurs de phase du troisième bloc sont configurés pour être polarisés selon un troisième potentiel de phase. Les blocs 10, 20, 30 peuvent être séparés les uns des autres par des espaces de séparation. Cela permet d'isoler les dissipateurs de phase qui ne sont pas au même potentiel. Les espaces de séparation peuvent comprendre des cartes de commande 700' et de la mousse isolante, comme illustré précédemment dans d'autres modes de réalisation.

Le busbar 100 est ici configuré pour délivrer les premier, deuxième, troisième potentiels de phase et les potentiels +DC et -DC.

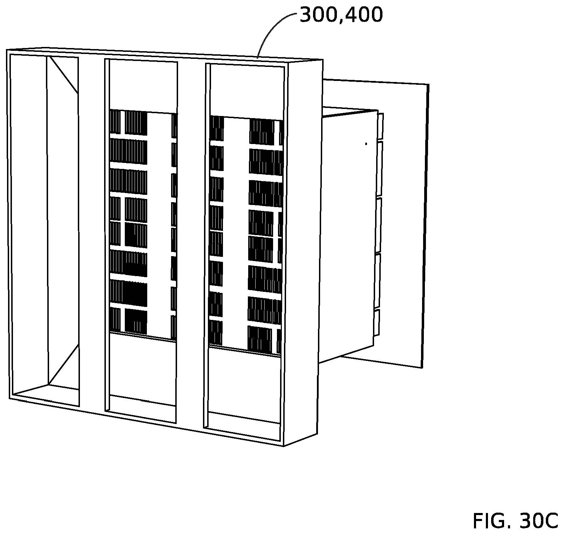

La figure 30B illustre un mode de réalisation comprenant une carte mère 700" perforée, reliant les cartes de commande 700, 700'. Les cartes 700 et 700" peuvent servir d'écran CEM. La figure 30C illustre un boitier 300, 400 associé au système illustré à la figure 30B.

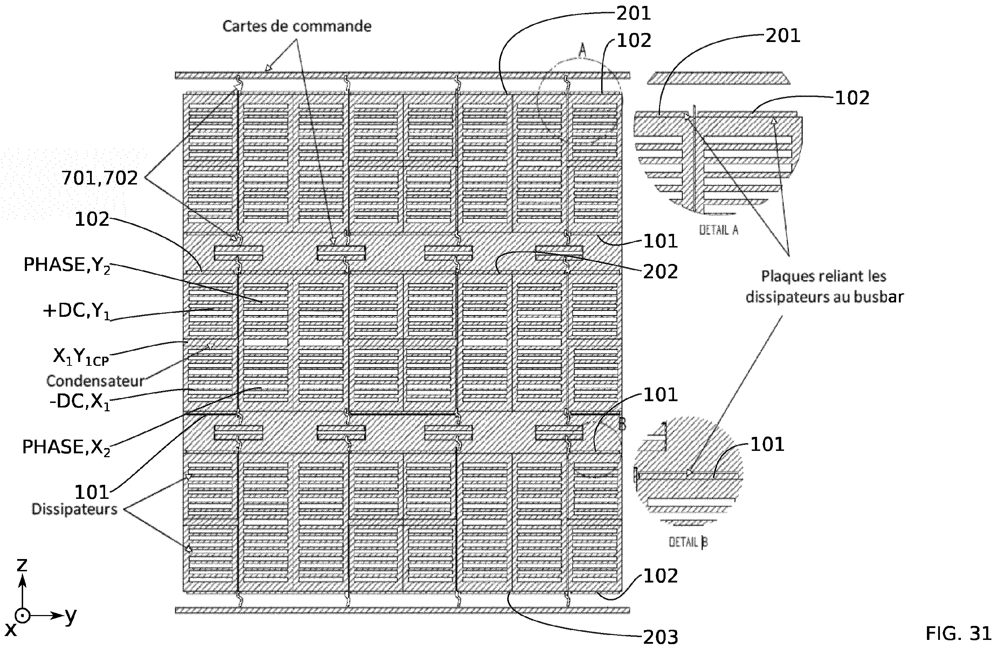

La figure 31 présente une coupe du système d'onduleur triphasé de la figure 30A, où l'on voit les connexions 701, 702 entre les cartes de commande 700, 700' et les cellules élémentaires. Les plaques de connexion 101, 102 reliant le busbar 100 aux dissipateurs anodiques et cathodiques, et les plaques de connexion 201, 202, 203 reliant le busbar 100 aux dissipateurs de phase respectivement polarisés selon les premier, deuxième, troisième potentiels de phase, sont également visibles sur la figure 31.

D'autres arrangements de cellules élémentaires et/ou de modules élémentaires peuvent être envisagés pour former d'autres systèmes électroniques.

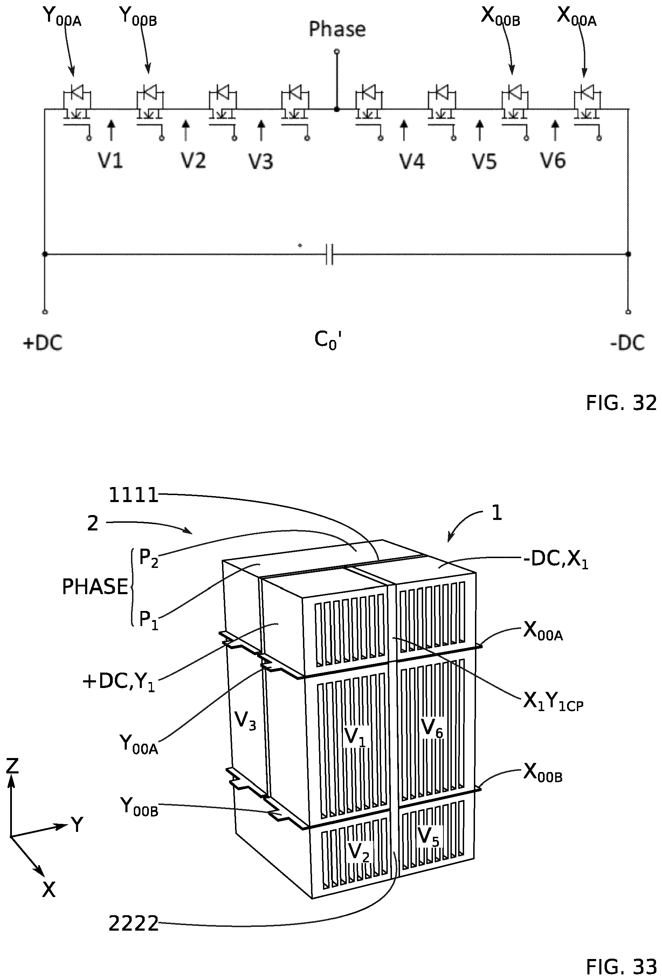

La figure 32 illustre un schéma électrique d'une cellule de commutation dans laquelle chaque bras comprend quatre composants de puissance en série. Les potentiels +DC, -DC, phase et des potentiels intermédiaires notés V1 à V6 sont reportés sur cette figure 32, de façon à clarifier les connexions internes aux modules élémentaires.

Dans cet exemple d'arrangement, la cellule de commutation comprend deux modules élémentaires formés comme suit :
Le premier module élémentaire comprend, dans l'ordre de connexion suivant:
- un dissipateur cathodique,
- un premier composant,
- un dissipateur intermédiaire polarisé selon V1,
- un deuxième composant,
- un dissipateur intermédiaire polarisé selon V2,
- un troisième composant,
- un dissipateur intermédiaire polarisé selon V3,
- un quatrième composant,
- un dissipateur de phase.

Le deuxième module élémentaire comprend, dans l'ordre de connexion suivant:
- un dissipateur anodique,
- un cinquième composant,
- un dissipateur intermédiaire polarisé selon V6,
- un sixième composant,
- un dissipateur intermédiaire polarisé selon V5,
- un septième composant,
- un dissipateur intermédiaire polarisé selon V4,
- un huitième composant,
- un dissipateur de phase.

Les dissipateurs anodique et cathodique sont connectés par une connexion électrique capacitive, par exemple axiale ou latérale. Les dissipateurs de phase sont connectés par une connexion électrique conductrice. Les dissipateurs intermédiaires sont isolés les uns des autres.

Les figures 33 à 39 illustrent différents modes de réalisation pratiques du système électronique défini à la figure 32.

Selon un mode de réalisation illustré à la figure 33, les composants élémentaires sont situés selon deux plans xy superposés, et les dissipateurs de phase P1, P2 sont alignés avec les dissipateurs anodique et cathodique X1, Y1 selon la direction x d'écoulement du fluide de refroidissement. La connexion électrique capacitive X1Y1CP entre les dissipateurs anodique et cathodique est latérale, comme décrit précédemment. Les dissipateurs de phase sont isolés vis-à-vis des dissipateurs anodique et cathodique par un isolant 1111 laissant passer le fluide de refroidissement, par exemple une mousse isolante.

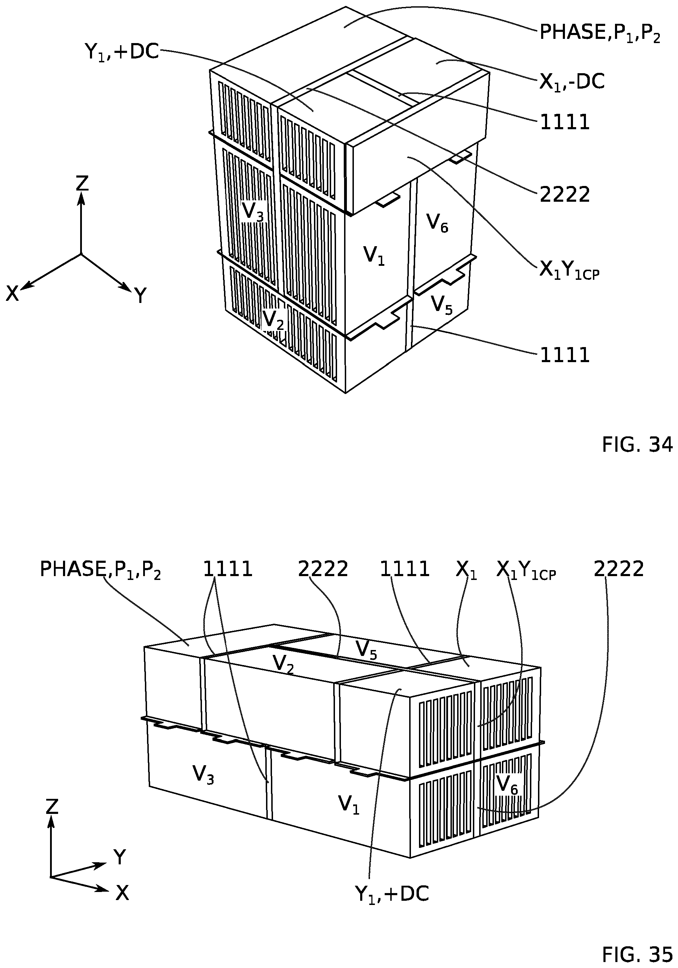

Selon un mode de réalisation illustré à la figure 34, les composants élémentaires sont situés selon deux plans xy superposés, et les dissipateurs de phase P1, P2 sont adjacents aux dissipateurs anodique et cathodique X1, Y1 selon la direction latérale y. La connexion électrique capacitive X1Y1CP entre les dissipateurs anodique et cathodique est ici axiale. Elle s'étend parallèlement à la direction x d'écoulement du fluide de refroidissement, afin d'éviter un blocage de l'écoulement. Les dissipateurs de phase sont isolés vis-à-vis des dissipateurs anodique et cathodique par un isolant 2222, qui n'est pas nécessairement perméable au fluide de refroidissement.

Dans les deux cas illustrés aux figures 33, 34, les dissipateurs adjacents qui sont polarisés selon des potentiels différents doivent être isolés électriquement entre eux par des isolants électriques 1111, 2222. Certains isolants 1111 sont configurés pour laisser passer le fluide de refroidissement. Les dissipateurs intermédiaires polarisés aux potentiels V1, V3, V4 et V6 peuvent être réalisés avec des dissipateurs plus hauts que les autres, selon z, dits dissipateurs XL. Cela permet de garder la même surface d'échange de part et d'autre de chaque composant élémentaire. Selon une possibilité, chacun de ces dissipateurs intermédiaires XL peut être remplacé par deux dissipateurs « standards » identiques aux autres et assemblés selon une connexion électrique conductrice centrale.

Selon un mode de réalisation illustré à la figure 35, les composants élémentaires sont tous situés dans un même plan xy, et les dissipateurs de phase P1, P2 sont alignés avec les dissipateurs anodique et cathodique X1, Y1 selon la direction x d'écoulement du fluide de refroidissement. La connexion électrique capacitive X1Y1CP entre les dissipateurs anodique et cathodique est latérale, comme décrit précédemment. Dans cet exemple, les dissipateurs intermédiaires aux potentiels V2, V3 sont intercalés entre les dissipateurs de phase P1, P2 et les dissipateurs anodique et cathodique X1, Y1 selon la direction x.

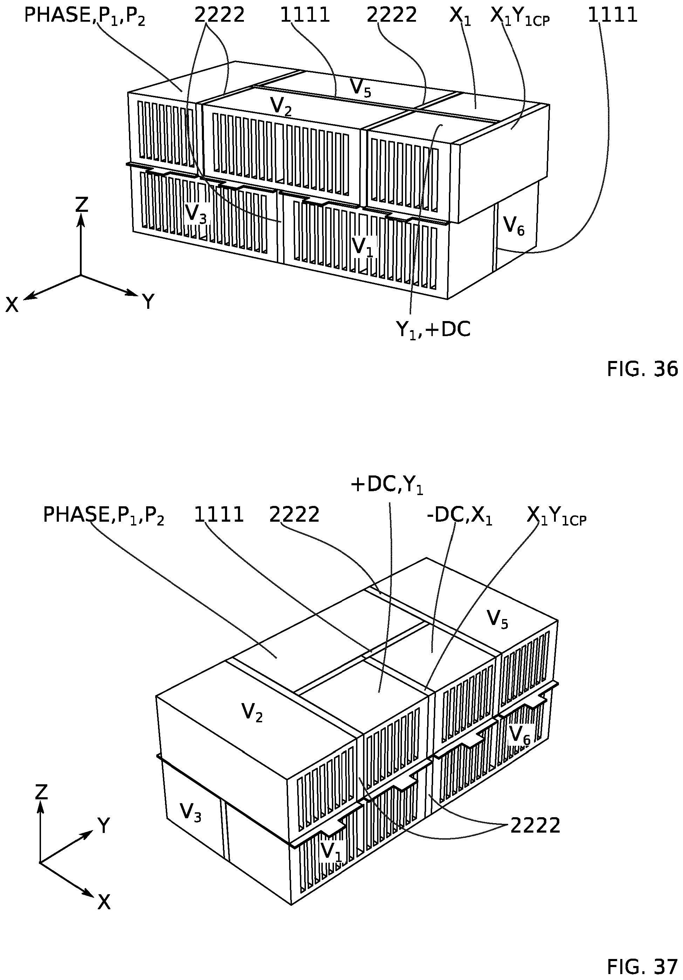

Selon un mode de réalisation illustré à la figure 36, les composants élémentaires sont tous situés dans un même plan xy, et les dissipateurs de phase P1, P2 sont adjacents aux dissipateurs intermédiaires aux potentiels V2, V3, selon la direction latérale y. Les dissipateurs anodique et cathodique X1, Y1 sont également adjacents aux dissipateurs intermédiaires aux potentiels V2, V3, selon la direction latérale y. La connexion électrique capacitive X1Y1CP entre les dissipateurs anodique et cathodique est axiale. Dans cet exemple, les dissipateurs intermédiaires aux potentiels V2, V3 sont intercalés entre les dissipateurs de phase P1, P2 et les dissipateurs anodique et cathodique X1, Y1 selon la direction y. Les pertes de charge de l'écoulement selon x sont réduites dans ce mode de réalisation.

Comme précédemment, des isolants électriques 1111, 2222 respectivement perméables ou éventuellement non perméables permettent d'isoler électriquement les dissipateurs adjacents qui sont polarisés selon des potentiels différents.

Selon un mode de réalisation illustré à la figure 37, les composants élémentaires sont tous situés dans un même plan xy, et les dissipateurs de phase P1, P2 sont alignés avec les dissipateurs anodique et cathodique X1, Y1 selon la direction x d'écoulement du fluide de refroidissement. La connexion électrique capacitive X1Y1CP entre les dissipateurs anodique et cathodique est latérale, comme décrit précédemment. Dans cet exemple, les dissipateurs de phase P1, P2 et les dissipateurs anodique et cathodique X1, Y1 sont adjacents. Les pertes de charge de l'écoulement selon x sont réduites dans ce mode de réalisation.

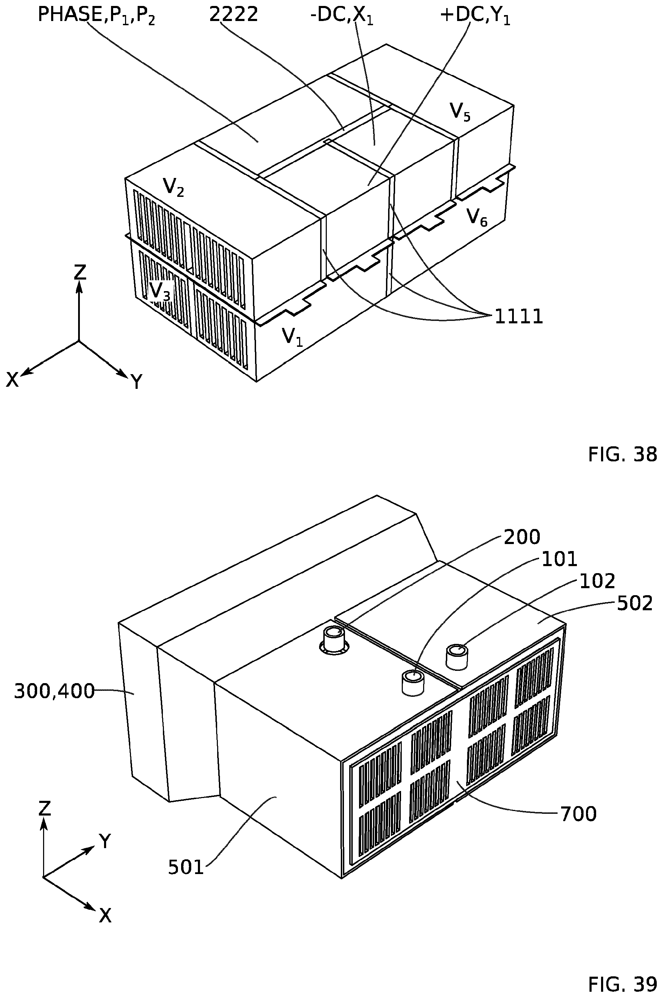

Selon un mode de réalisation illustré à la figure 38, les composants élémentaires sont tous situés dans un même plan xy, et les dissipateurs de phase P1, P2 sont adjacents aux dissipateurs anodique et cathodique X1, Y1, selon la direction latérale y. La connexion électrique capacitive X1Y1CP entre les dissipateurs anodique et cathodique est axiale (non illustrée).

Dans les deux cas illustrés aux figures 37, 38, ce type d'assemblage permet de modifier les capacités et inductances parasites au sein de la cellule de commutation par rapport aux exemples précédents. Cela permet de modifier et d'adapter le comportement du système électronique lors des commutations, en fonction des besoins.

Comme précédemment, des isolants électriques 1111, 2222 respectivement perméables ou éventuellement non perméables permettent d'isoler électriquement les dissipateurs adjacents qui sont polarisés selon des potentiels différents.

La figure 39 illustre les éléments additionnels (boitier 300, 400, carte de commande perforée 700, écrans CEM 501, 502, connexions externes -DC 101, +DC 102, de phase 200) ajoutés au système électronique illustré à la figure 37.

D'autres modes de réalisation de systèmes électroniques sont facilement envisageables à partir des exemples décrits et illustrés dans cette demande.

## Revendications

1. Système électronique de puissance comprenant une pluralité de composants de puissance (X00A, Y00A) et une pluralité de dissipateurs thermiques conducteurs électriques (X1, X2, Y1, Y2, U1, U2, V1, V2, A1, A2, B1, B2, 11, I2, J1, J2), chacun desdits composants de puissance (X00A) étant disposé entre deux dissipateurs thermiques conducteurs électriques (X1, X2) de la pluralité de dissipateurs thermiques conducteurs électriques, au moins un dissipateur thermique conducteur électrique étant configuré pour être polarisé selon un potentiel de phase, dit dissipateur de phase (X2, Y2, U2, V2, A2, B2, I2, J2), au moins un dissipateur thermique conducteur électrique étant configuré pour être polarisé selon un potentiel +DC, dit dissipateur cathodique (Y1, V1, B1, J1), et au moins un dissipateur thermique conducteur électrique configuré pour être polarisé selon un potentiel -DC, dit dissipateur anodique (X1, U1, A1, I1), le système comprenant en outre au moins une connexion externe de phase (200, 201, 202), et au moins une connexion externe +DC (100, 101), et au moins une connexion externe - DC (100, 102) respectivement connectées au dissipateur de phase, au dissipateur cathodique et au dissipateur anodique,
dans lequel les composants de puissance et les dissipateurs thermiques conducteurs électriques sont assemblés de sorte à former des cellules de commutation élémentaires (C0, C01, C02, C03, C04) connectées en parallèle, chaque cellule de commutation élémentaire comprenant :
- Un premier module électronique de puissance élémentaire (1), dit premier module élémentaire (1),
- Un deuxième module électronique de puissance élémentaire (2), dit deuxième module élémentaire (2),
le premier module élémentaire (1) comprenant :
- un dissipateur thermique conducteur électrique (X1) configuré pour être polarisé selon un potentiel -DC, dit dissipateur anodique (X1), et
- un dissipateur thermique conducteur électrique (X2) configuré pour être polarisé selon un potentiel de phase, dit premier dissipateur de phase (X2),
- un premier composant de puissance (X00A) disposé entre le dissipateur anodique (X1) et le premier dissipateur de phase (X2),
le deuxième module élémentaire (2) comprenant :
- un dissipateur thermique conducteur électrique (Y1) configuré pour être polarisé selon un potentiel +DC, dit dissipateur cathodique (Y1),
- un dissipateur thermique conducteur électrique (Y2) configuré pour être polarisé selon le potentiel de phase, dit deuxième dissipateur de phase (Y2),
- un deuxième composant de puissance (Y00A) disposé entre le dissipateur cathodique (Y1) et le deuxième dissipateur de phase (Y2),
Lesdits premier et deuxième modules élémentaires (1, 2) étant adjacents selon une direction de connexion latérale (y) et connectés entre eux par une connexion électrique latérale conductrice (X2Y2C) entre les premier et deuxième dissipateurs de phase, et par une connexion électrique latérale capacitive (X1Y1CP) entre les dissipateurs anodique et cathodique,
dans lequel les dissipateurs anodique et cathodique (X1, Y1) et les dissipateurs de phase (X2, Y2) des cellules de commutation élémentaires (C01) sont configurés pour laisser passer un fluide de refroidissement selon une direction axiale (x) normale à la direction de connexion latérale (y),
et
en ce que les cellules de commutation élémentaires (C01, C02, C03, C04) sont assemblées les unes derrière les autres selon la direction axiale (x), de sorte que les dissipateurs anodiques (X1, U1, A1, I1) desdites cellules soient alignés les uns derrière les autres selon la direction axiale (x), et que les dissipateurs cathodiques (Y1, V1, B1, J1) desdites cellules soient alignés les uns derrière les autres selon la direction axiale (x), et que les premiers dissipateurs de phase (X2, U2, A2, I2) desdites cellules soient alignés les uns derrière les autres selon la direction axiale (x), et que les deuxièmes dissipateurs de phase (Y2, V2, B2, J2) desdites cellules soient alignés les uns derrière les autres selon la direction axiale (x).

2. Système selon la revendication précédente dans lequel la connexion externe de phase (200) se fait sur un premier côté des cellules formé par les premiers et deuxièmes dissipateurs de phase (X2, Y2), et les connexions externes +DC et -DC se font sur un deuxième côté des cellules formé par les dissipateurs anodiques et cathodiques (X1, Y1), ledit deuxième côté étant opposé au premier côté.

3. Système selon l'une quelconque des revendications précédentes comprenant au moins un premier bloc (10) et un deuxième bloc (20) de cellules de commutation élémentaires assemblées les unes derrière les autres selon la direction (x) axiale, lesdits au moins premier et deuxième blocs (10, 20) étant adjacents et connectés selon une direction de connexion centrale (z) de sorte que les premiers et deuxièmes dissipateurs de phase (U2, V2, X2, Y2) du premier bloc (10) soient connectés aux premiers et deuxièmes dissipateurs de phase (A2, B2, I2, J2) du deuxième bloc (20).

4. Système selon la revendication précédente dans lequel les connexions externes +DC et -DC (101, 102) comprennent respectivement des raccords +DC et -DC configurés pour relier respectivement les dissipateurs cathodiques (B1, J1) du deuxième bloc avec les dissipateurs cathodiques du premier bloc (V1, Y1), et les dissipateurs anodiques du deuxième bloc (I1, A1) avec les dissipateurs anodiques (U1, X1) du premier bloc.

5. Système selon l'une quelconque des revendications précédentes comprenant au moins un premier bloc (10) et un deuxième bloc (20) de cellules de commutation élémentaires assemblées les unes derrière les autres selon la direction (x) axiale, lesdits au moins premier et deuxième blocs étant adjacents et séparés selon la direction de connexion latérale (y) par un espace de séparation (E).

6. Système selon la revendication précédente dans lequel l'espace de séparation (E) comprend au moins une carte de commande (700') configurée pour commander les composants de puissance des cellules de commutation élémentaires de chacun des premier et deuxième blocs, et un calfeutrage (70) configuré pour bloquer un passage du fluide de refroidissement.

7. Système selon l'une quelconque des deux revendications précédentes, dans lequel les dissipateurs cathodiques (Y1, V1, J1, B1) des premier et deuxième blocs bordent l'espace de séparation (E) ou dans lequel les dissipateurs anodiques (X1, U1, A1, I1) des premier et deuxième blocs bordent l'espace de séparation (E).

8. Système selon l'une quelconque des revendications 5 ou 6, dans lequel les dissipateurs cathodiques et anodiques (Y1, V1, J1, B1, X1, U1, A1, I1) des premier et deuxième blocs bordent l'espace de séparation et dans lequel les premiers et deuxièmes dissipateurs de phase (X2, Y2, U2, V2) du premier bloc (10) se trouvent sur un côté des cellules du premier bloc opposé à l'espace de séparation (E) et dans lequel les premiers et deuxièmes dissipateurs de phase (A2, I2, J2, B2) du deuxième bloc (20) se trouvent sur un côté des cellules du deuxième bloc opposé à l'espace de séparation.

9. Système selon la revendication précédente dans lequel l'espace de séparation (E) comprend les connexions externes +DC et -DC (101, 102) et dans lequel la connexion externe de phase (200) comprend un raccord de phase (200') configuré pour relier les premiers et deuxièmes dissipateurs de phase du deuxième bloc avec les premiers et deuxièmes dissipateurs de phase du premier bloc.

10. Système selon la revendication 5 ou 6 dans lequel les cellules de commutation élémentaires de chacun des premier et deuxième blocs sont assemblées les unes derrière les autres selon la direction (x) axiale, de sorte que le dissipateur anodique (U1) d'une cellule donnée soit aligné avec l'un parmi les premier et deuxième dissipateur de phase (X2, Y2) d'une cellule immédiatement adjacente selon la direction (x) axiale, et que le dissipateur cathodique (V1) de ladite cellule donnée soit aligné avec l'autre parmi les premier et deuxième dissipateur de phase (X2, Y2) de la cellule immédiatement adjacente selon la direction (x) axiale, lesdits dissipateurs anodiques et cathodiques étant isolés (1010, 2020) électriquement vis-à-vis desdits premier et deuxième dissipateurs de phase.

11. Système selon l'une quelconque des revendications précédentes dans lequel les connexions externes +DC et -DC (101, 102) sont reliées à un jeu de barres ou busbar (10), et dans lequel le busbar est disposé transversalement à la direction (x) axiale, le busbar (100) étant configuré pour laisser passer le fluide de refroidissement.

12. Système selon la revendication précédente dans lequel le busbar (100) se présente sous forme d'une grille perforée.

13. Système selon l'une quelconque des revendications précédentes comprenant en outre au moins une carte de commande (700, 701, 702) entourant les cellules de commutation élémentaires, de sorte à ce que ladite au moins une carte de commande forme un boîtier configuré pour canaliser le fluide de refroidissement selon la direction (x) axiale.

14. Système selon l'une quelconque des revendications précédentes dans lequel une première partie des cellules de commutation élémentaires présente des premiers et deuxièmes dissipateurs de phase configurés pour être polarisés selon un premier potentiel de phase et une deuxième partie des cellules de commutation élémentaires présente des premiers et deuxièmes dissipateurs de phase isolés (2122) électriquement vis-à-vis des premiers et deuxièmes dissipateurs de phase de la première partie des cellules, et configurés pour être polarisés selon un deuxième potentiel de phase différent du premier potentiel de phase, et dans lequel l'au moins une connexion externe de phase (200) comprend une première connexion externe de phase (201) connectée aux dissipateurs polarisés selon le premier potentiel de phase, et une deuxième connexion externe de phase (202) connectée aux dissipateurs polarisés selon le deuxième potentiel de phase.

15. Système selon la revendication précédente dans lequel les cellules de commutation élémentaires de la première partie sont connectées via leurs premiers et deuxièmes dissipateurs de phase (X2, Y2, A2, B2) selon une direction de connexion centrale (z), et les cellules de commutation élémentaires de la deuxième partie sont connectées via leurs premiers et deuxièmes dissipateurs de phase (U2, I2, J2, V2) selon la direction de connexion centrale (z), de sorte que les dissipateurs de phase des cellules de la première partie soient alignés avec les dissipateurs de phase des cellules de la deuxième partie selon la direction (x) axiale.

16. Système selon la revendication 14 dans lequel les cellules de commutation élémentaires de la première partie sont connectées via leurs premiers et deuxièmes dissipateurs de phase (X2, Y2, U2, V2) selon la direction (x) axiale, et les cellules de commutation élémentaires de la deuxième partie sont connectées via leurs premiers et deuxièmes dissipateurs de phase (B2, A2, I2, J2) selon la direction (x) axiale, de sorte que les dissipateurs de phase des cellules de la première partie soient alignés avec les dissipateurs de phase des cellules de la deuxième partie selon une direction de connexion centrale (z).

17. Système selon la revendication 14 dans lequel une troisième partie (30) des cellules de commutation élémentaires présente des premiers et deuxièmes dissipateurs de phase configurés pour être polarisés selon un troisième potentiel de phase, et dans lequel l'au moins une connexion externe de phase comprend une troisième connexion externe de phase connectée aux dissipateurs polarisés selon le troisième potentiel de phase.

18. Système selon l'une quelconque des revendications précédentes comprenant en outre un boîtier (300, 400) configuré pour entourer la pluralité de dissipateurs thermiques conducteurs électriques de façon à canaliser un passage d'un fluide de refroidissement dans lesdits dissipateurs thermiques conducteurs électriques.

19. Système selon l'une quelconque des revendications précédentes comprenant en outre au moins un écran de comptabilité électromagnétique (501, 502) configuré pour être polarisé selon le potentiel +DC ou -DC, entourant au moins partiellement l'au moins un dissipateur de phase.

20. Système selon l'une quelconque des revendications précédentes comprenant en outre au moins une carte de commande (700, 701, 702, 700' 700") configurée pour commander la pluralité de composants de puissance et entourant au moins partiellement la pluralité de dissipateurs thermiques conducteurs électriques.

## Patentansprüche

1. Leistungselektroniksystem, das eine Vielzahl von Leistungskomponenten (X00A, Y00A) und eine Vielzahl von elektrisch leitenden Kühlkörpern (X1, X2, Y1, Y2, U1, U2, V1, V2, A1, A2, B1, B2, I1, I2, J1, J2) umfasst, wobei jede der Leistungskomponenten (X00A) zwischen zwei elektrisch leitenden Kühlkörpern (X1, X2) der Vielzahl von elektrisch leitenden Kühlkörpern angeordnet ist, wobei mindestens ein elektrisch leitender Kühlkörper so eingerichtet ist, dass er gemäß einem Phasenpotenzial polarisiert ist, und als Phasenkühlkörper (X2, Y2, U2, V2, A2, B2, I2, J2), bezeichnet wird, mindestens ein elektrisch leitender Kühlkörper so eingerichtet ist, dass er gemäß einem +DC-Potenzial polarisiert ist, und als Kathodenkühlkörper (Y1, V1, B1, J1) bezeichnet wird, und mindestens ein elektrisch leitender Kühlkörper so eingerichtet ist, dass er gemäß einem -DC-Potenzial polarisiert ist, und als Anodenkühlkörper (X1, U1, A1, I1) bezeichnet wird, wobei das System ferner mindestens eine externe Phasenverbindung (200, 201, 202) und mindestens eine externe +DC-Verbindung (100, 101) und mindestens eine externe -DC-Verbindung (100, 102) umfasst, die jeweils mit dem Phasenkühlkörper, dem Kathodenkühlkörper und dem Anodenkühlkörper verbunden sind,
wobei die Leistungskomponenten und die elektrisch leitenden Kühlkörper so zusammengebaut sind, dass sie parallel geschaltete elementare Schaltzellen (C0, C01, C02, C03, C04) bilden, wobei jede elementare Schaltzelle Folgendes umfasst:
- ein erstes elementares Leistungselektronikmodul (1), das als erstes elementares Modul (1) bezeichnet wird,
- ein zweites elementares Leistungselektronikmodul (2), das als zweites elementares Modul (2) bezeichnet wird, wobei das erste elementare Modul (1) Folgendes umfasst:
- einen elektrisch leitenden Kühlkörper (X1), der so eingerichtet ist, dass er gemäß einem -DC-Potenzial polarisiert ist, und als Anodenkühlkörper (X1) bezeichnet wird, und
- einen elektrisch leitenden Kühlkörper (X2), der so eingerichtet ist, dass er gemäß einem Phasenpotenzial polarisiert ist, und als erster Phasenkühlkörper (X2) bezeichnet wird,
- eine erste Leistungskomponente (X00A), die zwischen dem Anodenkühlkörper (X1) und dem ersten Phasenkühlkörper (X2) angeordnet ist,
wobei das zweite elementare Modul (2) Folgendes umfasst:
- einen elektrisch leitenden Kühlkörper (Y1), der so eingerichtet ist, dass er gemäß einem +DC-Potenzial polarisiert ist, und als Kathodenkühlkörper (Y1) bezeichnet wird,
- einen elektrisch leitenden Kühlkörper (Y2), der so eingerichtet ist, dass er gemäß dem Phasenpotenzial polarisiert ist, und als zweiter Phasenkühlkörper (Y2) bezeichnet wird,
- eine zweite Leistungskomponente (Y00A), die zwischen dem Kathodenkühlkörper (Y1) und dem zweiten Phasenkühlkörper (Y2) angeordnet ist,
wobei das erste und das zweite elementare Modul (1, 2) in einer seitlichen Verbindungsrichtung (y) benachbart sind und durch eine leitende seitliche elektrische Verbindung (X2Y2C) zwischen dem ersten und dem zweiten Phasenkühlkörper und durch eine kapazitive seitliche elektrische Verbindung (X1Y1CP) zwischen dem Anoden- und dem Kathodenkühlkörper miteinander verbunden sind,
wobei der Anoden- und der Kathodenkühlkörper (X1, Y1) und die Phasenkühlkörper (X2, Y2) der elementaren Schaltzellen (C01) so eingerichtet sind, dass sie ein Kühlmittel in einer axialen Richtung (x), die senkrecht zur seitlichen Verbindungsrichtung (y) verläuft, durchlassen,
und dass die elementaren Schaltzellen (C01, C02, C03, C04) in der axialen Richtung (x) hintereinander so zusammengebaut sind, dass die Anodenkühlkörper (X1, U1, A1, I1) der Zellen in der axialen Richtung (x) hintereinander ausgerichtet sind, und dass die Kathodenkühlkörper (Y1, V1, B1, J1) der Zellen in der axialen Richtung (x) hintereinander ausgerichtet sind, und dass die ersten Phasenkühlkörper (X2, U2, A2, I2) der Zellen in der axialen Richtung (x) hintereinander ausgerichtet sind, und dass die zweiten Phasenkühlkörper (Y2, V2, B2, J2) der Zellen in der axialen Richtung (x) hintereinander ausgerichtet sind.

2. System nach dem vorhergehenden Anspruch, wobei die externe Phasenverbindung (200) auf einer ersten Seite der Zellen erfolgt, die von dem ersten und dem zweiten Phasenkühlkörper (X2, Y2) gebildet wird, und die externen +DC- und -DC-Verbindungen auf einer zweiten Seite der Zellen erfolgen, die von dem Anoden- und dem Kathodenkühlkörper (X1, Y1) gebildet wird, wobei die zweite Seite der ersten Seite gegenübersteht.

3. System nach einem der vorhergehenden Ansprüche, das mindestens einen ersten Block (10) und einen zweiten Block (20) von elementaren Schaltzellen umfasst, die in der axialen Richtung (x) hintereinander zusammengebaut sind, wobei der mindestens erste und der mindestens zweite Block (10, 20) benachbart sind und in einer zentralen Verbindungsrichtung (z) verbunden sind, so dass die ersten und die zweiten Phasenkühlkörper (U2, V2, X2, Y2) des ersten Blocks (10) mit den ersten und den zweiten Phasenkühlkörpern (A2, B2, I2, J2) des zweiten Blocks (20) verbunden sind.

4. System nach dem vorhergehenden Anspruch, wobei die externen +DC- und -DC-Verbindungen (101, 102) jeweils +DC- und -DC-Anschlüsse umfassen, die so eingerichtet sind, dass sie die Kathodenkühlkörper (B1, J1) des zweiten Blocks mit den Kathodenkühlkörpern des ersten Blocks (V1, Y1) und die Anodenkühlkörper des zweiten Blocks (I1, A1) mit den Anodenkühlkörpern (U1, X1) des ersten Blocks verbinden.

5. System nach einem der vorhergehenden Ansprüche, das mindestens einen ersten Block (10) und einen zweiten Block (20) von elementaren Schaltzellen umfasst, die in der axialen Richtung (x) hintereinander zusammengebaut sind, wobei der mindestens erste und der mindestens zweite Block benachbart sind und in der seitlichen Verbindungsrichtung (y) durch einen Trennungsraum (E) getrennt sind.

6. System nach dem vorhergehenden Anspruch, wobei der Trennungsraum (E) mindestens eine Steuerplatine (700'), die so eingerichtet ist, dass sie die Leistungskomponenten der elementaren Schaltzellen jeweils des ersten und des zweiten Blocks steuert, und eine Dichtung (70) umfasst, die so eingerichtet ist, dass sie einen Durchgang des Kühlmittels blockiert.

7. System nach einem der beiden vorhergehenden Ansprüche, wobei die Kathodenkühlkörper (Y1, V1, J1, B1) des ersten und des zweiten Blocks den Trennungsraum (E) begrenzen oder wobei die Anodenkühlkörper (X1, U1, A1, I1) des ersten und des zweiten Blocks den Trennungsraum (E) begrenzen.

8. System nach einem der Ansprüche 5 oder 6, wobei die Kathoden- und die Anodenkühlkörper (Y1, V1, J1, B1, X1, U1, A1, I1) des ersten und des zweiten Blocks den Trennungsraum begrenzen und wobei sich die ersten und die zweiten Phasenkühlkörper (X2, Y2, U2, V2) des ersten Blocks (10) auf einer dem Trennungsraum (E) gegenüberliegenden Seite der Zellen des ersten Blocks befinden und wobei sich die ersten und die zweiten Phasenkühlkörper (A2, I2, J2, B2) des zweiten Blocks (20) auf einer dem Trennungsraum gegenüberliegenden Seite der Zellen des zweiten Blocks befinden.

9. System nach dem vorhergehenden Anspruch, wobei der Trennungsraum (E) die externen +DC- und -DC-Verbindungen (101, 102) umfasst und wobei die externe Phasenverbindung (200) einen Phasenanschluss (200') umfasst, der so eingerichtet ist, dass er die ersten und die zweiten Phasenkühlkörper des zweiten Blocks mit den ersten und den zweiten Phasenkühlkörpern des ersten Blocks verbindet.

10. System nach Anspruch 5 oder 6, wobei die elementaren Schaltzellen jeweils des ersten und des zweiten Blocks in der axialen Richtung (x) so hintereinander zusammengebaut sind, dass der Anodenkühlkörper (U1) einer gegebenen Zelle mit einem von dem ersten und dem zweiten Phasenkühlkörper (X2, Y2) einer unmittelbar benachbarten Zelle in der axialen Richtung (x) ausgerichtet ist und dass der Kathodenkühlkörper (V1) der gegebenen Zelle mit dem anderen von dem ersten und dem zweiten Phasenkühlkörper (X2, Y2) der unmittelbar benachbarten Zelle in der axialen Richtung (x) ausgerichtet ist, wobei die Anoden- und Kathodenkühlkörper (1010, 2020) gegenüber den ersten und zweiten Phasenkühlkörpern elektrisch isoliert sind.

11. System nach einem der vorhergehenden Ansprüche, wobei die externen +DC- und -DC-Verbindungen (101, 102) mit einer Stromschiene oder Sammelschiene (10) verbunden sind, und wobei die Sammelschiene quer zur axialen Richtung (x) angeordnet ist, wobei die Sammelschiene (100) so eingerichtet ist, dass sie das Kühlmittel durchlässt.

12. System nach dem vorhergehenden Anspruch, wobei die Sammelschiene (100) in Form eines perforierten Gitters vorliegt.

13. System nach einem der vorhergehenden Ansprüche, das ferner mindestens eine Steuerplatine (700, 701, 702) umfasst, die die elementaren Schaltzellen umgibt, so dass die mindestens eine Steuerplatine ein Gehäuse bildet, das so eingerichtet ist, dass es das Kühlmittel in die axiale Richtung (x) leitet.

14. System nach einem der vorhergehenden Ansprüche, wobei ein erster Teil der elementaren Schaltzellen erste und zweite Phasenkühlkörper aufweist, die so eingerichtet sind, dass sie gemäß einem ersten Phasenpotenzial polarisiert sind, und ein zweiter Teil der elementaren Schaltzellen erste und zweite Phasenkühlkörper (2122) aufweist, die gegenüber den ersten und zweiten Phasenkühlkörpern des ersten Teils der Zellen elektrisch isoliert und so eingerichtet sind, dass sie gemäß einem zweiten Phasenpotenzial polarisiert sind, das sich vom ersten Phasenpotenzial unterscheidet, und wobei die mindestens eine äußere Phasenverbindung (200) eine erste externe Phasenverbindung (201), die mit den gemäß dem ersten Phasenpotenzial polarisierten Kühlkörpern verbunden ist, und eine zweite externe Phasenverbindung (202) umfasst, die mit den gemäß dem zweiten Phasenpotenzial polarisierten Kühlkörpern verbunden ist.

15. System nach dem vorhergehenden Anspruch, wobei die elementaren Schaltzellen des ersten Teils über ihre ersten und zweiten Phasenkühlkörper (X2, Y2, A2, B2) in einer zentralen Verbindungsrichtung (z) verbunden sind und die elementaren Schaltzellen des zweiten Teils über ihre ersten und zweiten Phasenkühlkörper (U2, I2, J2, V2) in der zentralen Verbindungsrichtung (z) verbunden sind, so dass die Phasenkühlkörper der Zellen des ersten Teils mit den Phasenkühlkörpern der Zellen des zweiten Teils in der axialen Richtung (x) ausgerichtet sind.

16. System nach Anspruch 14, wobei die elementaren Schaltzellen des ersten Teils über ihre ersten und zweiten Phasenkühlkörper (X2, Y2, U2, V2) in der axialen Richtung (x) verbunden sind und die elementaren Schaltzellen des zweiten Teils über ihre ersten und zweiten Phasenkühlkörper (B2, A2, I2, J2) in der axialen Richtung (x) verbunden sind, so dass die Phasenkühlkörper der Zellen des ersten Teils mit den Phasenkühlkörpern der Zellen des zweiten Teils in einer zentralen Verbindungsrichtung (z) ausgerichtet sind.

17. System nach Anspruch 14, wobei ein dritter Teil (30) der elementaren Schaltzellen erste und zweite Phasenkühlkörper aufweist, die so eingerichtet sind, dass sie gemäß einem dritten Phasenpotenzial polarisiert sind, und wobei die mindestens eine externe Phasenverbindung eine dritte externe Phasenverbindung umfasst, die mit den gemäß dem dritten Phasenpotenzial polarisierten Kühlkörpern verbunden ist.

18. System nach einem der vorhergehenden Ansprüche, das ferner ein Gehäuse (300, 400) umfasst, das so eingerichtet ist, dass es die Vielzahl von elektrisch leitenden Kühlkörpern umgibt, um einen Durchgang eines Kühlmittels in den elektrisch leitenden Kühlkörper zu leiten.

19. System nach einem der vorhergehenden Ansprüche, das ferner mindestens eine elektromagnetische Kompatibilitätsabschirmung (501, 502) umfasst, die so eingerichtet ist, dass sie gemäß dem +DC- oder -DC-Potenzial polarisiert ist und den mindestens einen Phasenkühlkörper mindestens teilweise umgibt.

20. System nach einem der vorhergehenden Ansprüche, das ferner mindestens eine Steuerplatine (700, 701, 702, 700', 700") umfasst, die so eingerichtet ist, dass sie die Vielzahl von Leistungskomponenten steuert und die Vielzahl von elektrisch leitenden Kühlkörpern mindestens teilweise umgibt.

## Claims

1. Power electronic system comprising a plurality of power components (X00A, Y00A) and a plurality of electrically conductive heat dissipaters (X1, X2, Y1, Y2, U1, U2, V1, V2, A1, A2, B1, B2, I1, I2, J1, J2), each of said power components (X00A) being arranged between two electrically conductive heat dissipaters (X1, X2) of the plurality of electrically conductive heat dissipaters, at least one electrically conductive heat dissipater being configured to be polarised according to a phase potential, referred to as a phase dissipater (X2, Y2, U2, V2, A2, B2, I2, J2), at least one electrically conductive heat dissipater being configured to be polarised according to a +DC potential, referred to as a cathode dissipater (Y1, V1, B1, J1), and at least one electrically conductive heat dissipater configured to be polarised according to a -DC potential, referred to as an anode dissipater (X1, U1, A1, I1), the system further comprising at least one external phase connection (200, 201, 202), and at least one external +DC connection (100, 101), and at least one external -DC connection (100, 102) respectively connected to the phase dissipater, to the cathode dissipater and to the anode dissipater,
wherein the power components and the electrically conductive heat dissipaters are assembled so as to form elementary switching cells (C0, C01, C02, C03, C04) connected in parallel, each elementary switching cell comprising:
- a first elementary power electronics module (1), referred to as a first elementary module (1),
- a second elementary power electronics module (2), referred to as a second elementary module (2),
the first elementary module (1) comprising:
- an electrically conductive heat dissipater (X1) configured to be polarised according to a -DC potential, referred to as an anode dissipater (X1), and
- an electrically conductive heat dissipater (X2) configured to be polarised according to a phase potential, referred to as the first phase dissipater (X2),
- a first power component (X00A) arranged between the anode dissipater (X1) and the first phase dissipater (X2),
the second elementary module (2) comprising:
- an electrically conductive heat dissipater (Y1) configured to be polarised according to a +DC potential, referred to as a cathode dissipater (Y1),
- an electrically conductive heat dissipater (Y2) configured to be polarised according to the phase potential, referred to as a second phase dissipater (Y2),
- a second power component (Y00A) arranged between the cathode dissipater (Y1) and the second phase dissipater (Y2),
said first and second elementary modules (1, 2) being adjacent in a lateral connection direction (y) and connected together by a conductive lateral electrical connection (X2Y2C) between the first and second phase dissipaters, and by a capacitive lateral electrical connection (X1Y1CP) between the anode and cathode dissipaters,
wherein the anode and cathode dissipaters (X1, Y1) and the phase dissipaters (X2, Y2) of the elementary switching cells (C01) are configured to let a cooling fluid pass in an axial direction (x) normal to the lateral connection direction (y),
and in that the elementary switching cells (C01, C02, C03, C04) are assembled one behind the other in the axial direction (x), such that the anode dissipaters (X1, U1, A1, I1) of said cells are aligned one behind the other in the axial direction (x), and in that the cathode dissipaters (Y1, V1, B1, J1) of said cells are aligned one behind the other in the axial direction (x), and in that the first phase dissipaters (X2, U2, A2, I2) of said cells are aligned one behind the other in the axial direction (x), and in that the second phase dissipaters (Y2, V2, B2, J2) of said cells are aligned one behind the other in the axial direction (x).

2. System according to the preceding claim, wherein the external phase connection (200) is made on a first side of the cells formed by the first and second phase dissipaters (X2, Y2), and the external +DC and -DC connections are made on a second side of the cells formed by the anode and cathode dissipaters (X1, Y1), said second side being opposite the first side.

3. System according to any one of the preceding claims, comprising at least a first block (10) and a second block (20) of elementary switching cells assembled one behind the other in the axial direction (x), said at least first and second blocks (10, 20) being adjacent and connected in a central connection direction (z) so that the first and second phase dissipaters (U2, V2, X2, Y2) of the first block (10) are connected to the first and second phase dissipaters (A2, B2, I2, J2) of the second block (20).

4. System according to the preceding claim, wherein the external +DC and -DC connections (101, 102) respectively comprise +DC and -DC connectors configured to respectively connect the cathode dissipaters (B1, J1) of the second block with the cathode dissipaters of the first block (V1, Y1), and the anode dissipaters of the second block (I1, A1) with the anode dissipaters (U1, X1) of the first block.

5. System according to any one of the preceding claims, comprising at least a first block (10) and a second block (20) of elementary switching cells assembled one behind the other in the axial direction (x), said at least first and second blocks being adjacent and separated in the lateral connection direction (y) by a separation space (E).

6. System according to the preceding claim, wherein the separation space (E) comprises at least one control board (700') configured to control the power components of the elementary switching cells of each of the first and second blocks, and caulking (70) configured to block a passage of the cooling fluid.

7. System according to any one of the two preceding claims, wherein the cathode dissipaters (Y1, V1, J1, B1) of the first and second blocks border the separation space (E) or wherein the anode dissipaters (X1, U1, A1, I1) of the first and second blocks border the separation space (E).

8. System according to any one of claims 5 or 6, wherein the cathode and anode dissipaters (Y1, V1, J1, B1, X1, U1, A1, 11) of the first and second blocks border the separation space and wherein the first and second phase dissipaters (X2, Y2, U2, V2) of the first block (10) are located on a side of the cells of the first block opposite the separation space (E), and wherein the first and second phase dissipaters (A2, I2, J2, B2) of the second block (20) are located on a side of the cells of the second block opposite the separation space.

9. System according to the preceding claim, wherein the separation space (E) comprises the external +DC and -DC connections (101, 102) and wherein the external phase connection (200) comprises a phase connector (200') configured to connect the first and second phase dissipaters of the second block with the first and second phase dissipaters of the first block.

10. System according to claim 5 or 6, wherein the elementary switching cells of each of the first and second blocks are assembled one behind the other in the axial direction (x), so that the anode dissipater (U1) of a given cell is aligned with one of the first and second phase dissipaters (X2, Y2) of an immediately adjacent cell in the axial direction (x), and the cathode dissipater (V1) of said given cell is aligned with the other one of the first and second phase dissipaters (X2, Y2) of the immediately adjacent cell in the axial direction (x), said anode and cathode dissipaters (1010, 2020) being electrically insulated with respect to said first and second phase dissipaters.

11. System according to any one of the preceding claims, wherein the external +DC and -DC connections (101, 102) are connected to a busbar (10), and wherein the busbar is arranged transversely to the axial direction (x), the busbar (100) being configured to let the cooling fluid pass.

12. System according to the preceding claim, wherein the busbar (100) is in the form of a perforated grid.

13. System according to any one of the preceding claims, further comprising at least one control board (700, 701, 702) surrounding the elementary switching cells, such that said at least one control board forms a casing configured to channel the cooling fluid in the axial direction (x).

14. System according to any one of the preceding claims, wherein a first portion of the elementary switching cells has first and second phase dissipaters configured to be polarised according to a first phase potential and a second portion of the elementary switching cells has first and second phase dissipaters (2122) electrically insulated with respect to the first and second phase dissipaters of the first portion of cells, and configured to be polarised according to a second phase potential different from the first phase potential, and wherein the at least one external phase connection (200) comprises a first external phase connection (201) connected to the polarised dissipaters according to the first phase potential, and a second external phase connection (202) connected to the polarised dissipaters according to the second phase potential.

15. System according to the preceding claim, wherein the elementary switching cells of the first portion are connected via their first and second phase dissipaters (X2, Y2, A2, B2) in a central connection direction (z), and the elementary switching cells of the second portion are connected via their first and second phase dissipaters (U2, I2, J2, V2) in the central connection direction (z), such that the phase dissipaters of the cells of the first portion are aligned with the phase dissipaters of the cells of the second portion in the axial direction (x).

16. System according to claim 14, wherein the elementary switching cells of the first portion are connected via their first and second phase dissipaters (X2, Y2, U2, V2) in the axial direction (x), and the elementary switching cells of the second portion are connected via their first and second phase dissipaters (B2, A2, I2, J2) in the axial direction (x), such that the phase dissipaters of the cells of the first portion are aligned with the phase dissipaters of the cells of the second portion in a central connection direction (z).

17. System according to claim 14, wherein a third portion (30) of the elementary switching cells has first and second phase dissipaters configured to be polarised according to a third phase potential, and wherein the at least one external phase connection comprises a third external phase connection connected to the polarised dissipaters according to the third phase potential.

18. System according to any one of the preceding claims, further comprising a casing (300, 400) configured to surround the plurality of electrically conductive dissipaters, so as to channel a passage of a cooling fluid in said electrically conductive heat dissipaters.

19. System according to any one of the preceding claims, further comprising at least one electromagnetic compatibility shield (501, 502) configured to be polarised according to the +DC or -DC potential, at least partially surrounding the at least one phase dissipater.

20. System according to any one of the preceding claims, further comprising at least one control board (700, 701, 702, 700', 700") configured to control the plurality of power components and at least partially surrounding the plurality of electrically conductive heat dissipaters.
